(19) Europäisches Patentamt
European Patent Office
Office européen des brevets

(11) EP 0 578 836 B1

(12) **EUROPEAN PATENT SPECIFICATION**

(45) Date of publication and mention
of the grant of the patent:
**06.05.1999 Bulletin 1999/18**

(21) Application number: **93903324.7**

(22) Date of filing: **05.02.1993**

(51) Int Cl.⁶: **H01S 3/18**, H01S 3/094,
H01S 3/19

(86) International application number:
**PCT/JP93/00156**

(87) International publication number:
**WO 93/16513 (19.08.1993 Gazette 1993/20)**

(54) **SEMICONDUCTOR LASER ELEMENT AND LASER MANUFACTURED USING THE SAME**

HALBLEITERLASERELEMENT UND DAMIT HERGESTELLTER LASER

ELEMENT LASER A SEMI-CONDUCTEUR ET LASER FABRIQUE AU MOYEN D'UN TEL ELEMENT

(84) Designated Contracting States:
**DE FR GB IT NL**

(30) Priority: **05.02.1992 JP 20289/92**

(43) Date of publication of application:
**19.01.1994 Bulletin 1994/03**

(73) Proprietor: **MITSUI CHEMICALS, INC.
Tokyo (JP)**

(72) Inventors:
• **MURO, Kiyofumi
  Mitsui Petrochemical Industries,
  Chiba 299-02 (JP)**
• **FUJIMOTO, Tsuyoshi
  Mitsui Petrochemical Ind. Ltd.
  Chiba 299-02 (JP)**
• **YOSHIDA, Yuuji
  Mitsui Petrochemical Industries,
  Chiba 299-02 (JP)**
• **YAMADA, Yoshikazu
  Mitsui Petrochemical Industries
  Chiba 299-02 (JP)**
• **ISHIZAKA, Shoji
  Mitsui Petrochemical Industries,
  Chiba 299-02 (JP)**

(74) Representative: **Lehn, Werner, Dipl.-Ing. et al
Hoffmann Eitle,
Patent- und Rechtsanwälte,
Postfach 81 04 20
81904 München (DE)**

(56) References cited:
**EP-A- 0 348 941          JP-A- 2 150 087
JP-A-60 133 781          JP-A-61 015 385
US-A- 4 328 469**

• **APPLIED OPTICS., vol.19, no.17, September
1980, NEW YORK US pages 2940 - 2941 K. IGA
'Single mode conditions for GaInAsP/InP DH
strip waveguides with GaInAsP side bounding
layers'**
• **HETEROSTRUCTURE LASERS, PART A
FUNDAMENTAL PRINCIPLES, H,C CASEY, AND
M.B. PANISH, ACADEMIC PRESS NEW YORK
1978 pages 31 - 57**

Remarks:
The file contains technical information submitted
after the application was filed and not included in this
specification

EP 0 578 836 B1

## Description

<u>Technical Field</u>

The present invention relates generally to industrial fields in which high-output semiconductor lasers are employed for communications, optical recording on optical disks or the like, laser printers, laser medical treatments, laser machining, etc.. The present invention relates, more particularly, to a high-output semiconductor laser for a solid-state laser excitation requiring laser beams having an enhanced output and a small radiation angle or for a harmonic conversion element excitation and also to a laser device using this semiconductor laser.

<u>Background Arts</u>

It has been desired in many sectors that the output of the semiconductor laser be enhanced. A factor for hindering the output enhancement per single mode of the semiconductor laser is a exit surface fusion caused by the laser beam which is called a catastrophic optical damage (COD). The COD is conspicuous especially in an AlGaAs laser. Paying attention mainly to a reduction of a power density of the laser by expanding a laser guided mode, a weakly guiding laser having a thin active layer or a separate confinement type laser known as an LOC (Large Optical Cavity) structure have hitherto been examined.

Based on such a structure, however, a strong correlation exists between a refractive index and a bandgap of each mixed crystal in a variety of laser materials ranging from the AlGaAs system. It is therefore impossible to independently control a carrier confinement and an optical confinement in a waveguide.

In particular, the expansion of the guided mode requires the thin active layer in either the LOC structured laser or the weakly guiding laser for the output enhancement. Further, a wide active layer is needed for obtaining a high gain for oscillations in the expanded guided mode. A self-contradiction thus exists therein. As a matter of fact, a limit of the mode expansion in an epitaxial direction by the above-mentioned methods is approximately 1 $\mu$m at the maximum. A limit of the output thereof is on the order of 100 mW per single mode.

Besides, in the weakly guiding laser having the thin active layer, the guided mode in the laminated direction exhibits an exponential function profile. Hence, a radiation density in the active layer where the catastrophic optical damage is caused is high against the whole beam intensity. This is disadvantageous for the output enhancement. Besides, the guided mode has tails drawn deeply in the clad layers, and hence there is needed a growth of the clad layers that are considerably thick for the expansion of the guided mode.

In addition, both the guided mode (near-field pattern) and a beam radiation angle (far-field pattern) deviate largely from the Gaussian beam conceived as ideal one. There exists a problem in terms of a convergence of the beams in multiple applications.

On the other hand, there have been also examined lasers based on a so-called window structure in which the vicinity of an exit surface where a COD may occur is made transparent to the laser emission beam and a structure where a carrier injection is not effected in the vicinity of the exit surface. Those structures generally present, however, such problems that the astigmatism increases in addition to a complicated manufacturing process.

Further, there has been made an attempt to manufacture the high-output laser in the single mode by an optical feedback between a multiplicity of semiconductor lasers. The problem is, however, that the device becomes complicated.

US-4,328,469 discloses a high output power injection laser having all the features described in the preamble of claim 1.

In light of the above-discussed problems, it is an object of the present invention to provide a semiconductor laser element having improved design possibilities and better performance.

This object is achieved by a semiconductor laser element having the features of claim 1. Advantageous embodiments are described in the subclaims.

<u>Disclosure of Invention</u>

According to the present invention, barrier layers called "carrier block layers" in the following having barrier heights (and widths) enough to cancel a guiding characteristic of an active layer and perform a carrier confinement in the active layer are inserted on both sides of the active layer of an ordinary double hetero laser or a quantum well laser. It is therefore possible to perform the confinement in the guided mode and independently design an active layer thickness required for oscillations.

On this occasion, a guiding function of the active layer can be canceled by the carrier block layers by reducing the thickness of the active layer region and the thickness of these carrier block layers by a factor of several times the oscillation wavelength. Under such conditions, the wave guide layers are further formed, and clad layers having a small

2

difference of refractive index are formed at both sides of the wave guide layer for the purpose of controlling only light guiding. Formed alternatively are wide wave guide layers based on a graded-index structure of a straight line, a quadratic curve, etc.. It is thus possible to design the guided mode completely independently of the active layer design parameters, thereby obtaining a stable mode approximate to the Gaussian beams and the radiation beams having the high output and low dispersion angle.

With the intention of enhancing the output of the semiconductor laser by avoiding the concurrent optical damage on the exit surface and of decreasing a divergence angle of the beam radiation, it is required that the guided mode be expanded by setting to so-called weakly guiding. The optical gain in the active layer, however, has a certain limit as seen in the gain saturation of, e.g., the quantum well laser. For this reason, the wide active layer or multi quantum well structure are required for maintaining the oscillations in the expanded guided mode. This induces the self-contradiction with the weakly guiding structure and therefore causes a problem in terms of designing a laser diode having a high-output and a low radiation beam angle.

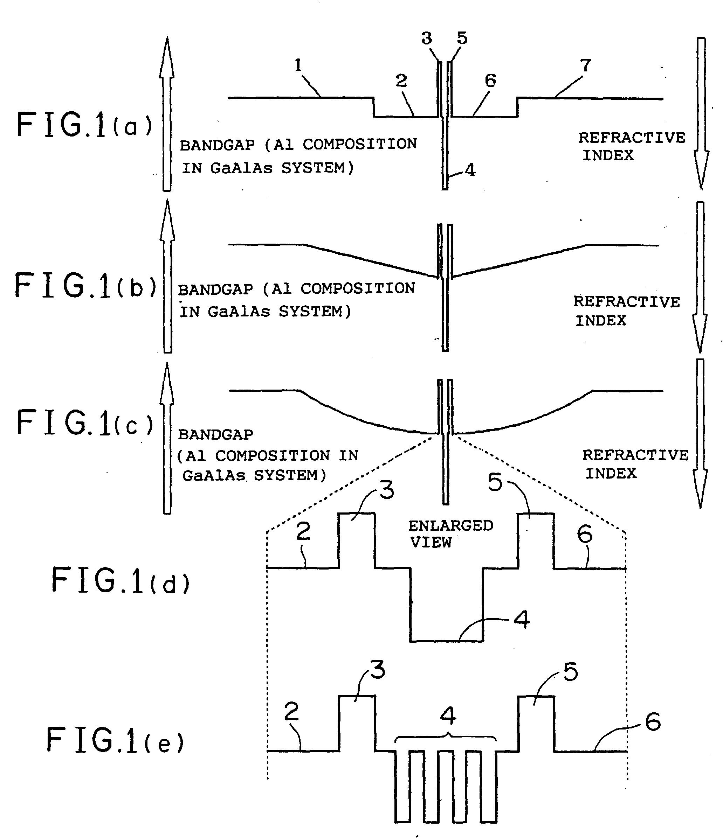

The number of the quantum wells and the thickness of the active layer for giving the necessary optical gain to the oscillations can be set independently of the waveguide structure because of the existence of the carrier block layers incorporating the anti-guiding function described above. Particularly, the guiding function of the active layer region is canceled by the anti-guiding function of the carrier block layers. The design of the active layer is compatible with the design of the guided mode by further separately introducing, into the wave guide layer, a mechanism for controlling the guided mode, as illustrated in FIGS. 1-(a), 1-(b) and 1-(c), a refractive index distribution of a stepped, straight line or quadratic curve. It is therefore feasible to obtain the stable waveguide mode approximate to the Gaussian beams having the high-output, and low beam divergence.

The present invention can be readily actualized by use of the thin film semiconductor manufacturing equipment such as a molecular beam epitaxial (MBE) system, a metal organic chemical vapor deposition (MOCVD) system or a metal organic molecular beam epitaxial (MOMBE) system. Further, the effects of this invention are remarkable in the laser diode using AlGa As alloy. Substantially the same effects can be, however, expected in a variety of III-V group semiconductor materials of a GaInAs system, an AlGaInAs system, a GaInAsP system and a AlGaInP system and further in various types of II-VI group semiconductor lasers.

As illustrated in FIG. 1, the carrier block layers are interposed on both sides of the active layer of the laser based on the conventional double hetero type structure or a multiple quantum well structure. The carrier block layers are composed of materials having a barrier height enough to effect a carrier confinement in the active layer, ie. a smaller refractive index and a wider gap than that of the wave guide layer. The carrier block layers also incorporate the function to cancel the guiding characteristic of the active layer, the anti-guiding function and the carrier block function.

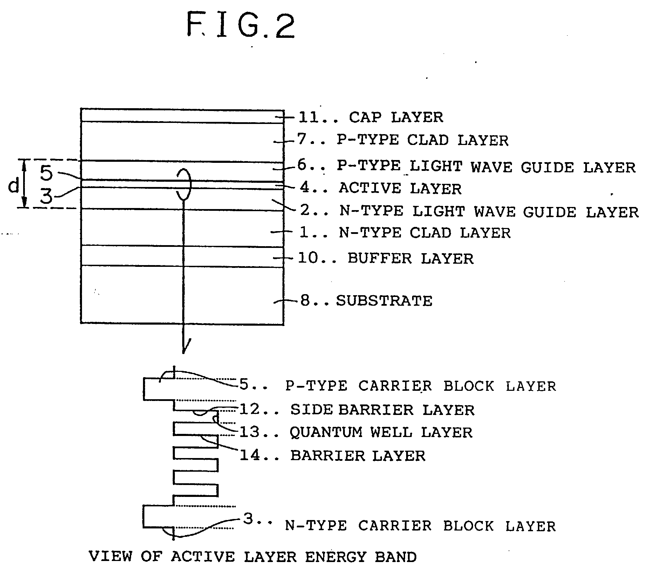

Further, it is possible to reduce a resistance due to the formation of a Schottky barrier on a band discontinuous surface and perform effective carrier blocking by performing P-doping on the order of $10^{18}/cm^3$ on the P-side of the carrier block layer and N-doping on the N-side shown in Fig. 2.

The cancellation of the guiding function of the active layer region by the carrier block layers having the anti-guiding function can be substantially attained when establishing the following relationship under such condition that a thickness of the both is several times smaller than the oscillation wavelength.

$$d_0 \bullet (N_1{}^2 - N_0{}^2)^{0.5} = 2 \bullet d_1 \, (N_0{}^2 - N_2{}^2)^{0.5}$$

where, as substantially shown in FIG. 1, $N_0$ is the refractive index of the wave guide layer, $N_1$, $d_0$ are respectively the refractive index and the thickness of the active layer, and $N_2$, $d_1$ are respectively the refractive index and the thickness of the carrier block layers. If the active layer is multi-layered as seen in the multiple quantum well structure, a quantity corresponding to the left side is calculated with respect to each layer. An added value thereof may be employed for the left side. More specifically, in the case of the active layer composed of the m quantum well layers having a thickness $d_w$ wherein a composition of the barrier layers between the quantum wells is the same as that of the wave guide layer, the guiding function of the active layer can be canceled by the barrier layer when establishing the following relationship:

$$m \bullet d_w \bullet (N_1{}^2 - N_0{}^2)^{0.5} = 2 \bullet d_1 \, (N_0{}^2 - N_2{}^2)^{0.5}$$

When the guiding function of the active layer is canceled by the carrier block layers, the guided mode is independently controllable by clad layers and the wave guide layers provided therearound. It is desirable that the waveguide is cut-off with respect to a higher-order mode for the single mode oscillations in any of the structures shown in FIGS. 1-(a), 1-(b) and 1-(c). Speaking of a step index type guiding mechanism shown in FIG. 1-(a), this guided mode can be described by the normalized frequency V. The normalized frequency V is defined by the following formula:

$$V = (\pi d / \lambda) \bullet (N_0{}^2 - N_3{}^2)^{0.5}$$

where $\pi$ is the ratio of the circumference of a circle to its diameter, $\lambda$ is the oscillation wavelength (angstrom), d is the thickness (angstrom) of the wave guide layer including the active layer and the carrier block layers, $N_0$ is the refractive index of the wave guide layer, and $N_3$ is the refractive index of the clad layer.

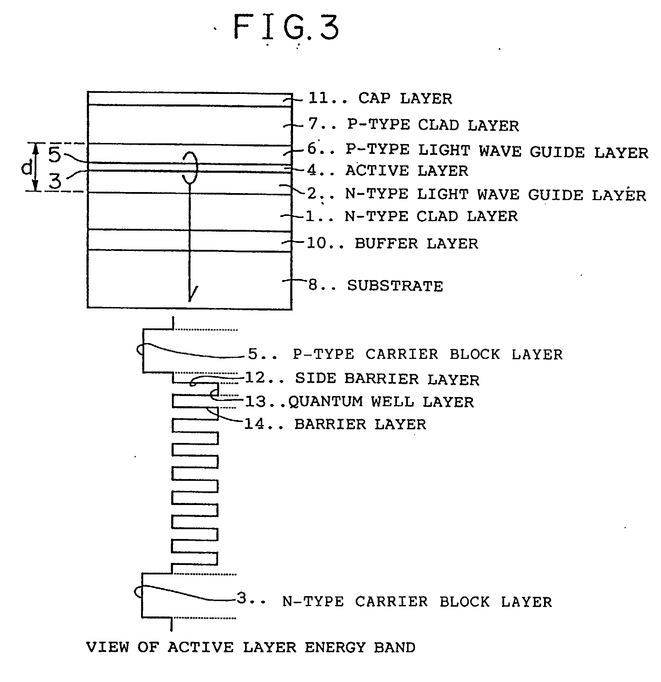

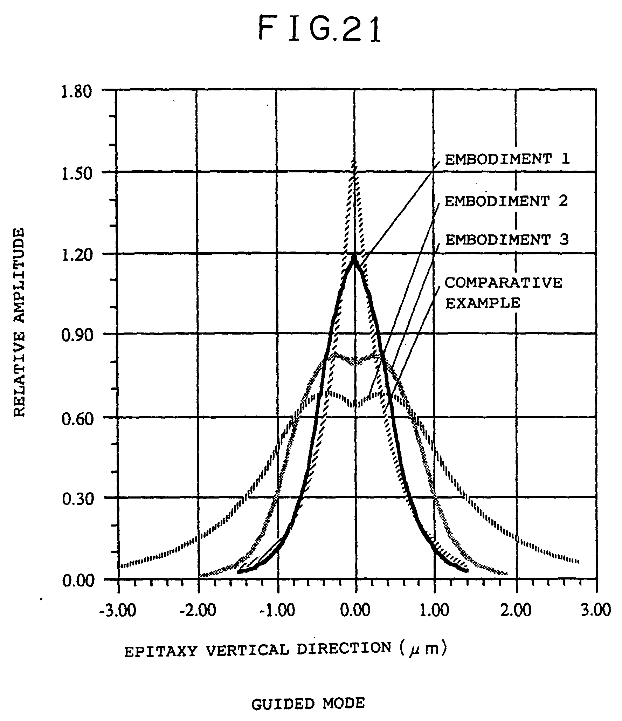

In a symmetric waveguide, when the normalized frequency V is $\pi/2$ or under, and single mode guiding is effected. Note that guided mode exhibits a profile of a sinusoidal function within the wave guide layer but a profile of a exponential function within the clad layers. When $V = \pi / 2$, a mode confinement rate in the wave guide layer is approximately 65%. Unlike the profile of the exponential function over the substantially entire area of the conventional weakly guiding laser, the guided mode approximates the Gaussian type (see FIG. 21). The structures (shown in FIGS. 2 and 3, respectively) in the embodiments 1 and 2 are designed substantially under this condition.

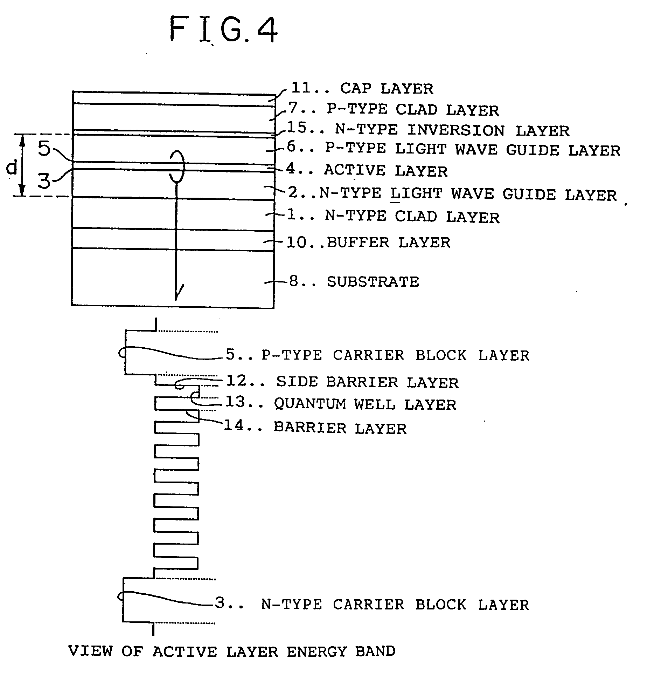

In the approximate-to-symmetry guiding structure, there is almost no possibility in which an odd-order mode is excited. Hence, even when making the mode more approximate to the Gaussian type by further increasing the normalized frequency V up to a level of $\pi$, the same effects can be acquired without causing multiple transverse mode oscillations. The embodiment 3 having the structure shown in FIG. 4 gives a design example where V is approximate to $\pi$.

More effectively, the oscillation mode can be made approximate to the Gaussian type by adopting the graded-index structure as shown in FIGS. 1-(b) and 1-(c).

We have repeated a trial manufacture of the semiconductor laser on the basis of the above-mentioned as a guideline and could obtain the following conditions with respect to the carrier block layer. $V_0$ is defined by:

$$V_0 = \pi \bullet d_0 / \lambda \bullet (N_1{}^2 - N_0{}^2)^{0.5}$$

where n is the ratio of the circumference of a circle to its diameter, $d_0$ is the thickness of the active layer, $\lambda$ is the oscillation wavelength, $N_1$ is the refractive index of the active layer and $N_0$ is the refractive index of the waveguide layer. If the active layer consists of N-pieces of multiple quantum wells, $V_0$ is expressed such as:

$$V_0 = N \bullet \pi \bullet d_w / \lambda \bullet (N_1{}^2 - N_0{}^2)^{0.5}$$

where $d_w$ is the thickness of the well layer, $N_1$ is the refractive index of the well layer, and $N_0$ is the refractive index of the wave guide layer.

Next, $V_1$ is defined such as:

$$V_1 = \pi \bullet d_1 / \lambda (N_0{}^2 - N_2{}^2)^{0.5}$$

where $\pi$ is the ratio of the circumference of a circle to its diameter, $d_1$ is the thickness of the carrier block layers, $N_2$ is the refractive index of the carrier block layers, and $N_0$ is the refractive index of the wave guide layer.

Next, $V_2$ is defined by:

$$V_2 = \pi \bullet d_2 / \lambda \bullet (N_0{}^2 - N_3{}^2)^{0.5}$$

where $\pi$ is the ratio of the circumference of a circle to its diameter, $d_2$ is the inter clad layer thickness, ie. the effective waveguide layer thickness, $N_0$ is the refractive index of the wave guide layer, and $N_3$ is the refractive index of the clad layer.

As obvious from the formulas described above, $V_0$, $V_1$, $V_2$ respectively correspond to the normalized frequencies of the active layer, the carrier block layers and the wave guide layer. If the anti-guiding function of the carrier block layers is too large, a reentrant is formed in the vicinity of the active layer in the guided mode. As a result, the optical confinement rate is decreased. This brings about an increment in the threshold current. Accordingly, an influence of the carrier block layer on the guided mode has to be lessened. According to the present invention, a variety of trial manufactures of the semiconductor laser have been repeated. Consequently, it was found out that the carrier block layer did not disturb the whole guided mode, where the following relationship is established:

$$V_1 < V_2 / 10$$

Moreover, it was also confirmed through the various trial manufactures of the semiconductor laser that especially the following condition is effective in canceling the guiding function of the active layer by the carrier block layer:

$$V_0 / 3 < V_1 < V_0$$

Furthermore, the carrier block layer has to effectively confine the carrier in the active layer. We have found out that the carrier can be sufficiently effectively confined in the active layer when $E > 2.5 \bullet 10^3 / d_1^2$, where $d_1$ (angstrom$=10^{-10}$m) is the thickness of the carrier block layer, and E (eV) is the energy gap difference between the wave guide layer and the carrier block layer.

Herein, the composition of the wave guide layer is set preferably to $Al_xGa_{1-x}As$ ($0 \leq x < 0.35$: where x is the atomic ratio) in the semiconductor laser using $Al_xGa_{1-x}As$. More specifically, when $\Delta x$ is the aluminium composition difference between the waveguide layer and the carrier block layer, the relationship between $\Delta x$ and the thickness $d_1$ (angstrom) of the carrier block layer preferably falls within the following range:

$$\Delta x > (2.2 \bullet 10^3 / d_1^2), \text{ and } \Delta x < (5.0 \bullet 10^4 / d_1^2)$$

Further, $V_0$ is given by:

$$V_0 = \pi \bullet d_0 / \lambda \bullet (N_1^2 - N_0^2)^{0.5}$$

where $d_0$ is the thickness of the active layer. If the active layer consists of N-pieces of quantum well layers, however, $V_0$ is defined by:

$$V_0 = N \bullet \pi \bullet d_w / \lambda \bullet (N_1^2 - N_0^2)^{0.5}$$

where $d_w$ is the thickness of the quantum well layer, $N_1$ is the refractive index of the quantum well layer, and $N_0$ is the refractive index of the wave guide layer. Then, a relationship therebetween is set preferably as follows:

$$(V_0 / 3) < V_1 < V_0$$

The carrier block layers has a large bandgap on both sides of the active layer but a small refractive index and incorporates an anti-guiding function. These carrier block layers act to reduce or cancel the guiding function incorporated into the active layer. Another function thereof is to block the injected carriers and acts to confine the electrons and holes in the active layer. This layer also undergoes P- or N-doping, thereby ameliorating the resistance reducing function or the carrier confinement function.

The guided mode control structure of the wave guide layer and the clad layer provides the action to control the expansion of the oscillation mode and the profile stably.

Brief Description of Drawings

[FIG. 1]

FIG. 1 is a schematic sectional view of a composition of a semiconductor laser in an epitaxial direction according to the invention.

[FIG. 2]

FIG. 2 is a schematic sectional view of a composition in an embodiment 1 of this invention.

[FIG. 3]

FIG. 3 is a schematic sectional view of a composition in an embodiment 2 of this invention.

[FIG. 4]

FIG. 4 is a schematic sectional view of a composition in an embodiment 3 of this invention.

[FIG. 5]

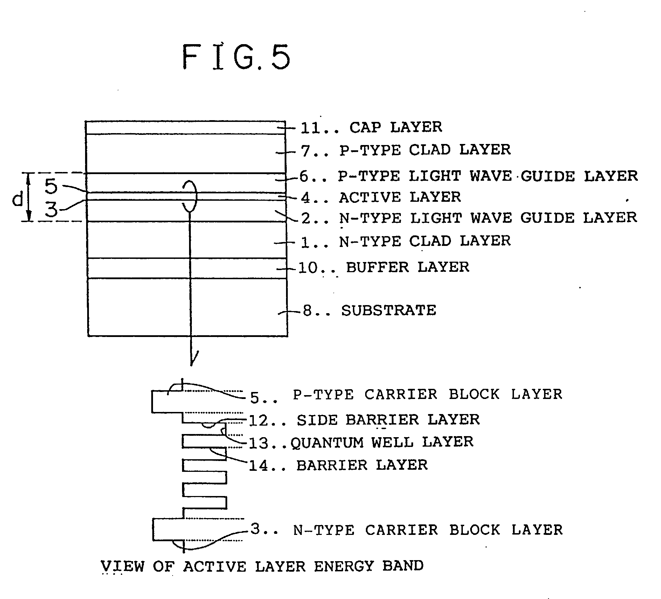

FIG. 5 is a schematic sectional view of a composition in an embodiment 4 of this invention.

[FIG. 6]

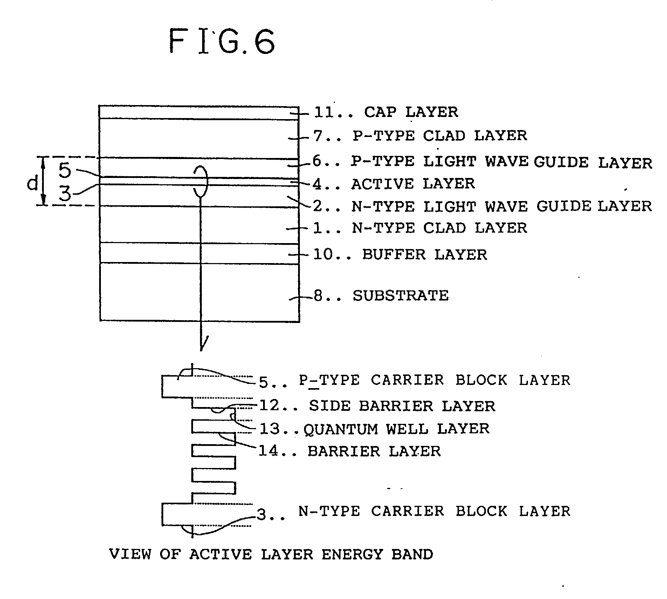

FIG. 6 is a schematic sectional view of a composition in an embodiment 5 of this invention.

[FIG. 7]

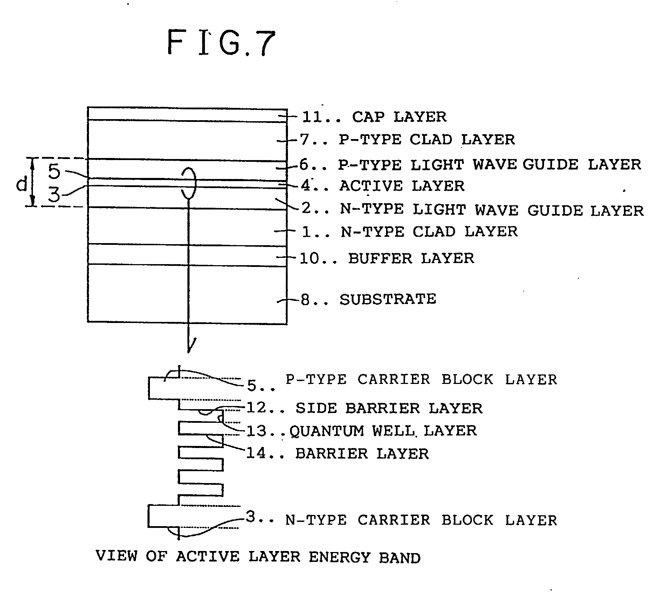

FIG. 7 is a schematic sectional view of a composition in an embodiment 6 of this invention.

[FIG. 8]

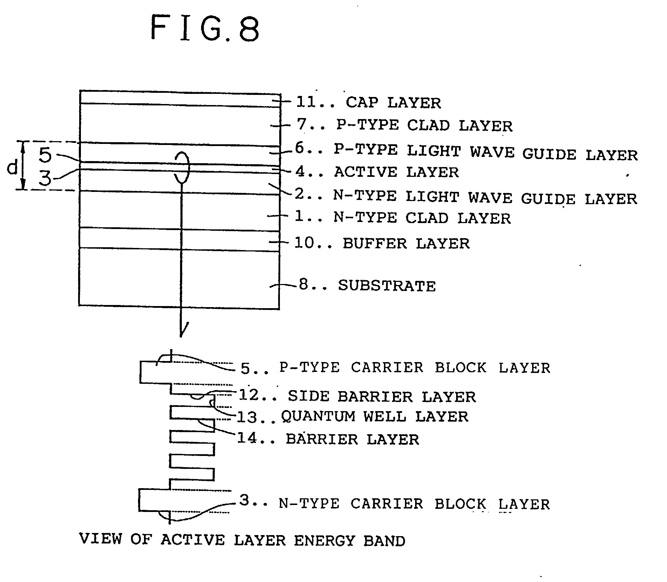

FIG. 8 is a schematic sectional view of a composition in an embodiment 7 of this invention.

[FIG. 9]

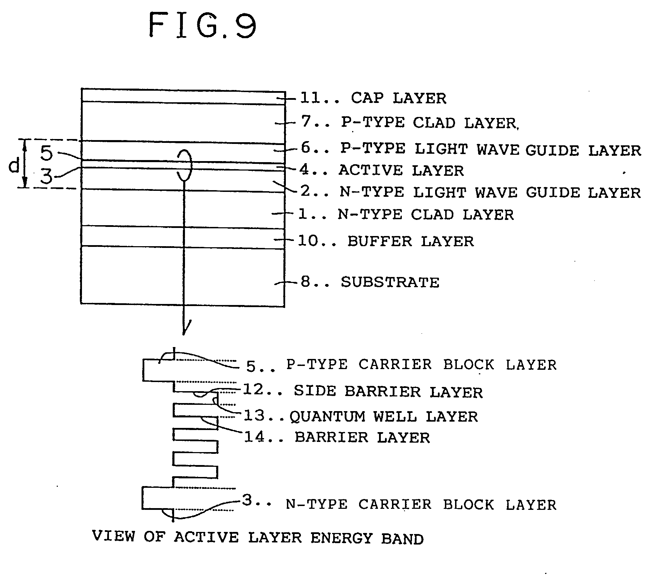

FIG. 9 is a schematic sectional view of a composition in an embodiment 8 of this invention.

[FIG. 10]

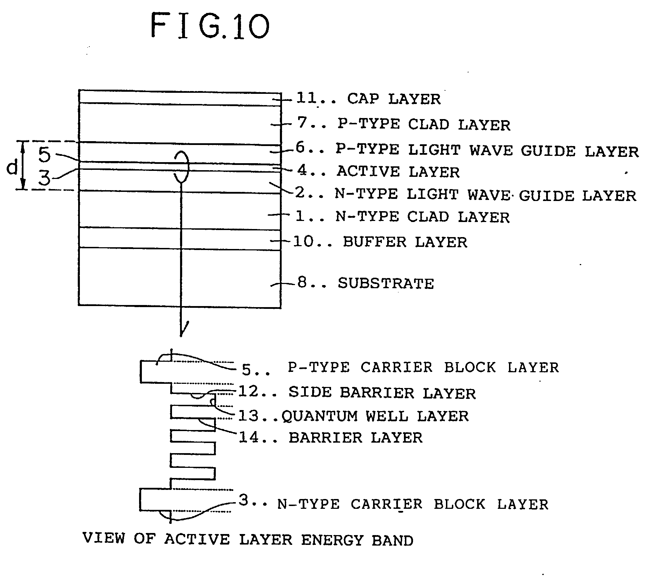

FIG. 10 is a schematic sectional view of a composition in an embodiment 9 of this invention.

[FIG. 11]

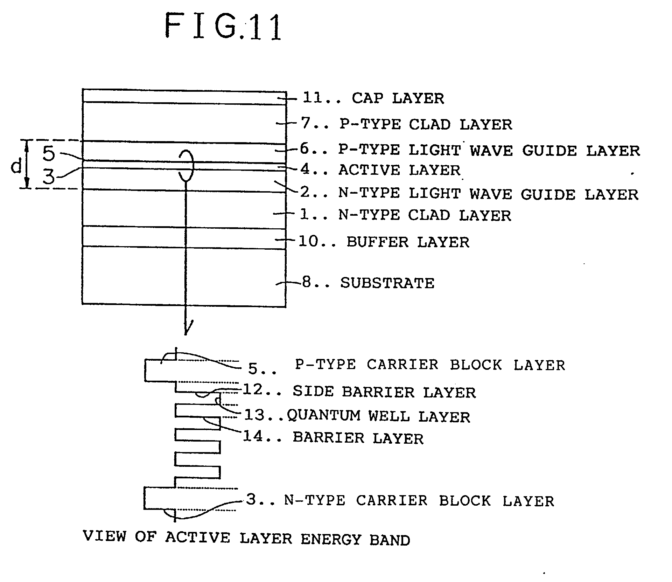

FIG. 11 is a schematic sectional view of a composition in an embodiment 10 of this invention.

[FIG. 12]

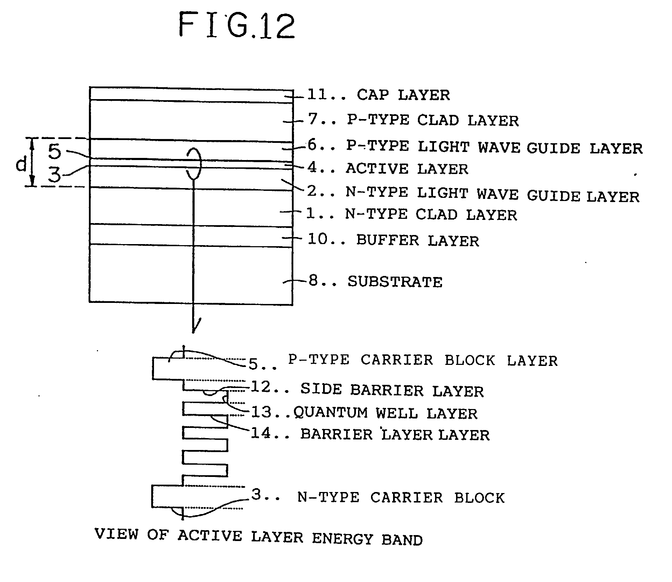

FIG. 12 is a schematic sectional view of a composition in an embodiment 11 of this invention.

[FIG. 13]

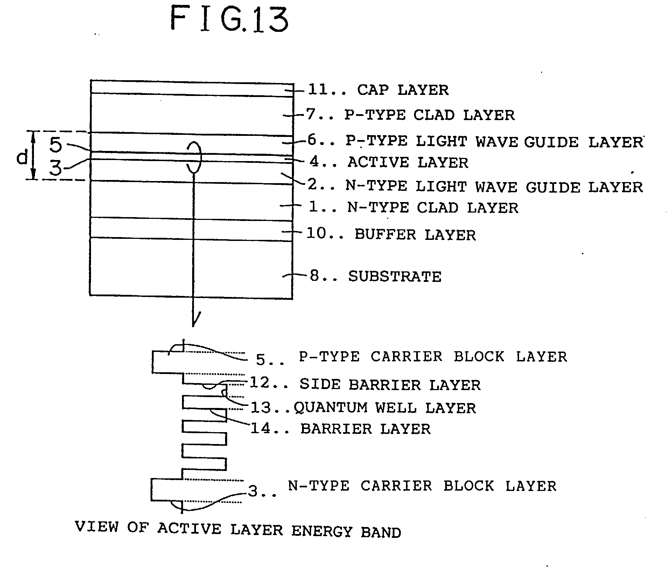

FIG. 13 is a schematic sectional view of a composition in an embodiment 12 of this invention.

[FIG. 14]

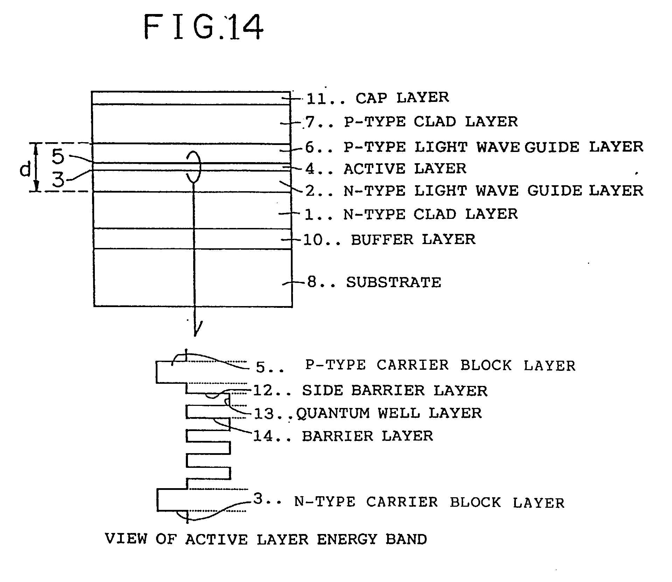

FIG. 14 is a schematic sectional view of a composition in an embodiment 13 of this invention.

[FIG. 15]

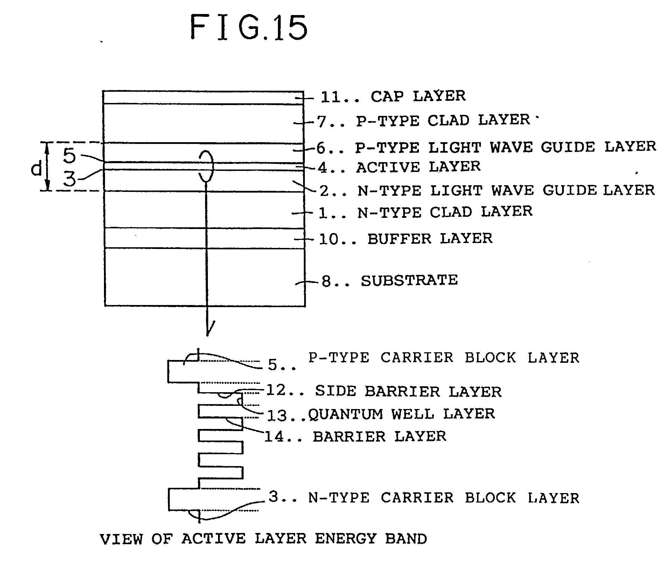

FIG. 15 is a schematic sectional view of a composition in an embodiment 14 of this invention.

[FIG. 16]

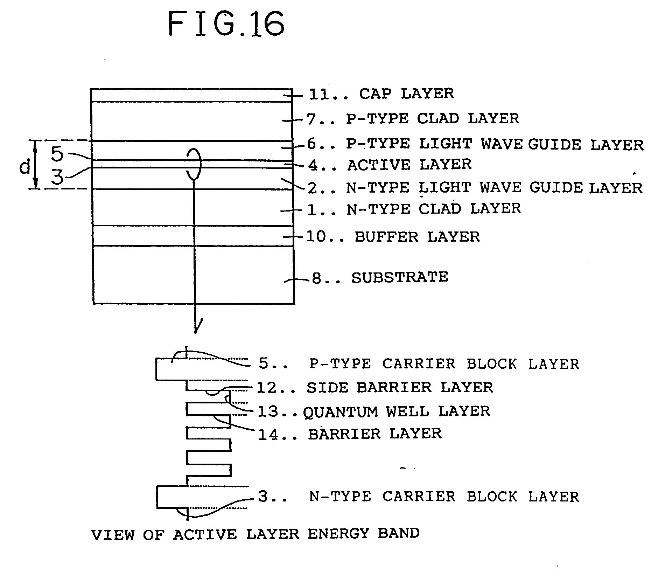

FIG. 16 is a schematic sectional view of a composition in an embodiment 15 of this invention.

[FIG. 17]

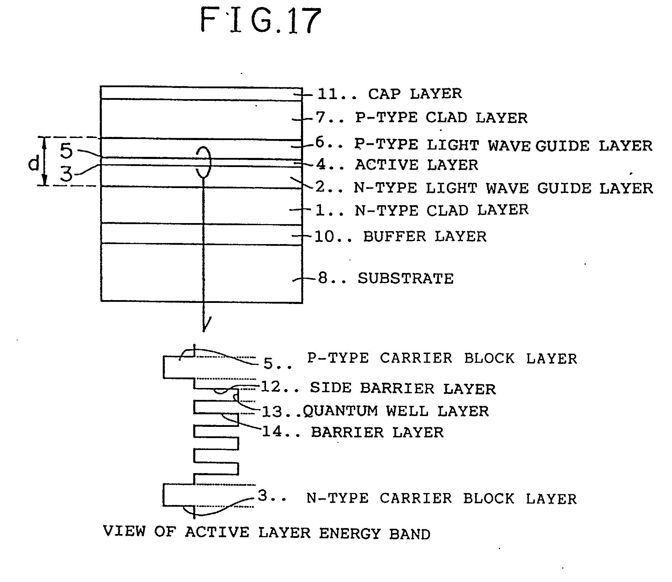

FIG. 17 is a schematic sectional view of a composition in an embodiment 16 of this invention.

[FIG. 18]

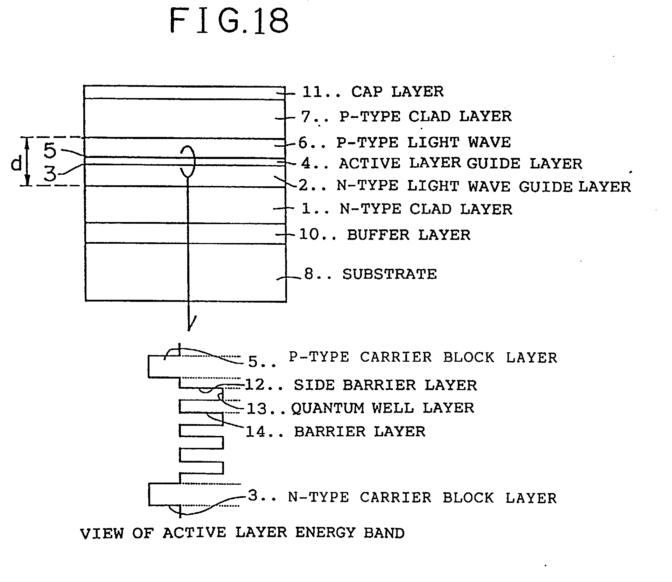

FIG. 18 is a schematic sectional view of a composition in an embodiment 17 of this invention.

[FIG. 19]

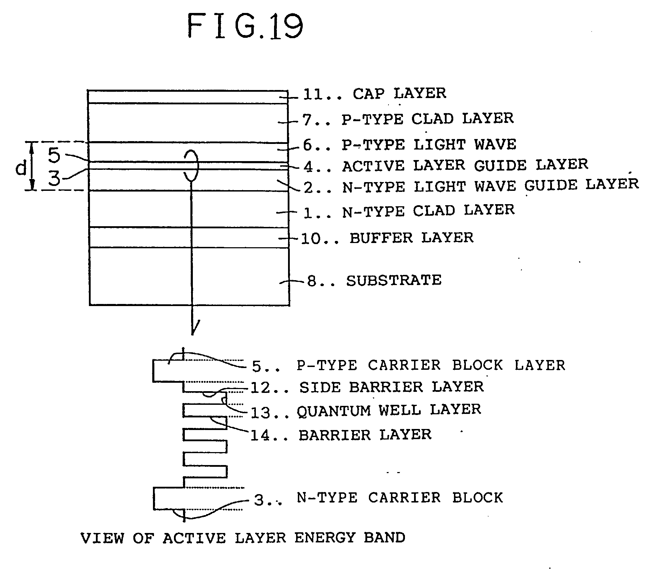

FIG. 19 is a schematic sectional view of a composition in an embodiment 18 of this invention.

[FIG. 20]

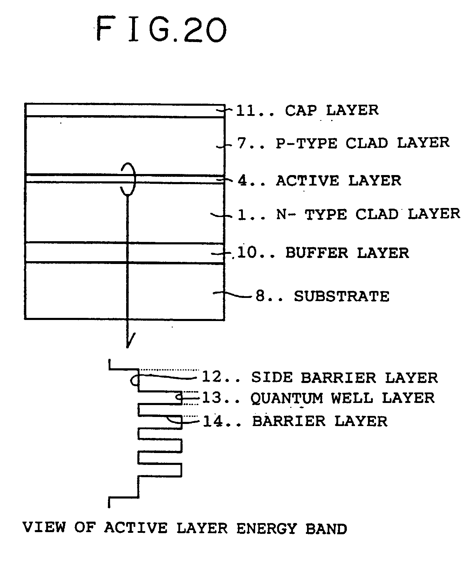

FIG. 20 is a schematic sectional view of a composition in a comparative example in relation to the present invention.

[FIG. 21]

FIG. 21 is a graphic chart showing guided mode characteristics in the embodiments 1 ~ 3 and a reference example.

[FIG. 22]

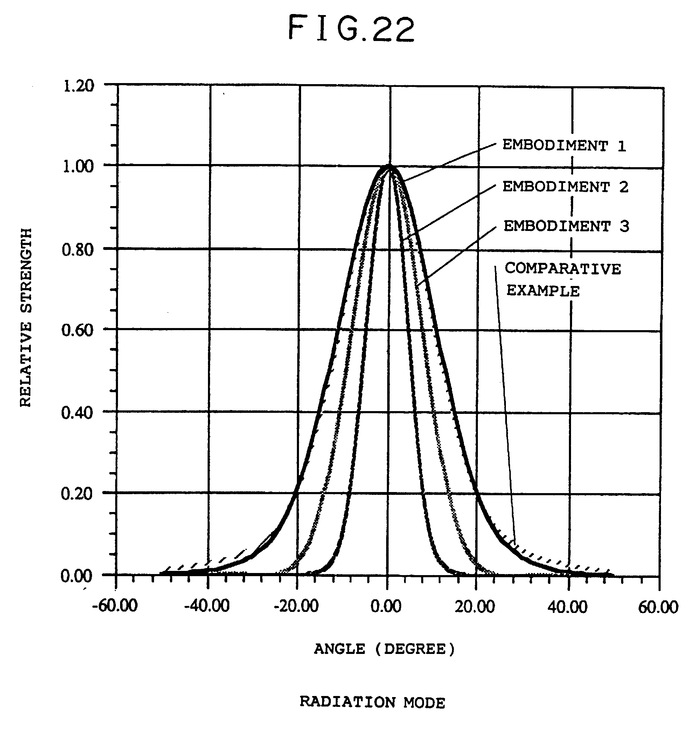

FIG. 22 is a graphic chart showing characteristics of a radiation beam angle in the embodiments 1 ~ 3 and the reference example.

[FIG. 23]

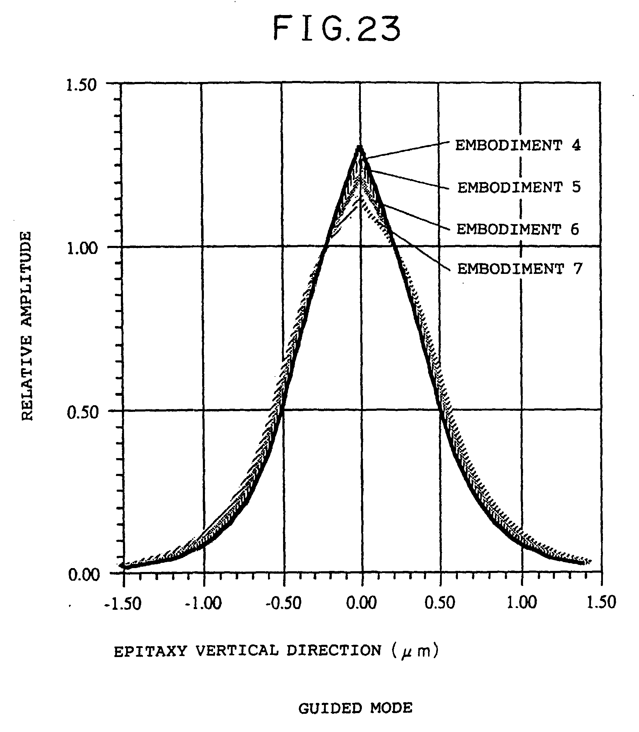

FIG. 23 is a graphic chart showing the guided mode characteristics in embodiments 4 ~ 7.

[FIG. 24]

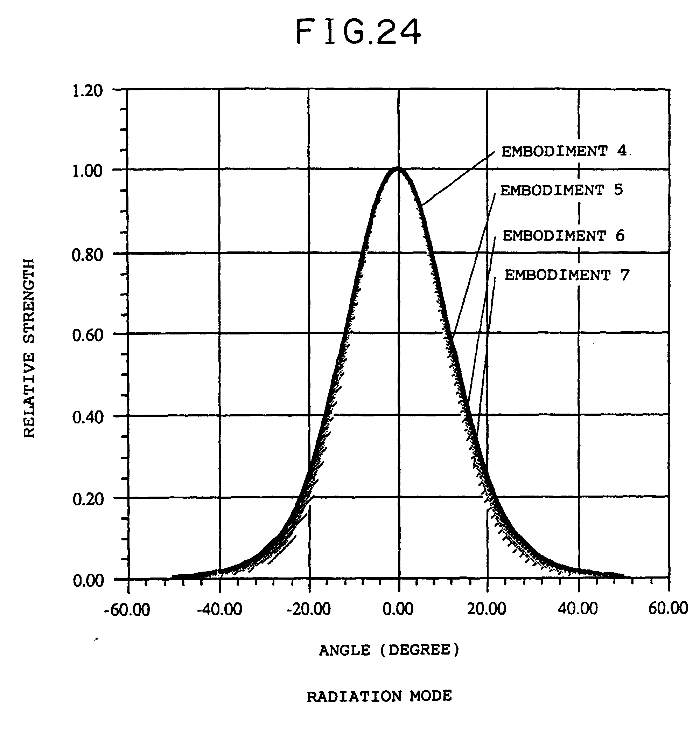

FIG. 24 is a graphic chart showing the characteristics of the radiation beam angle in the embodiments 4 ~ 7.

[FIG. 25]

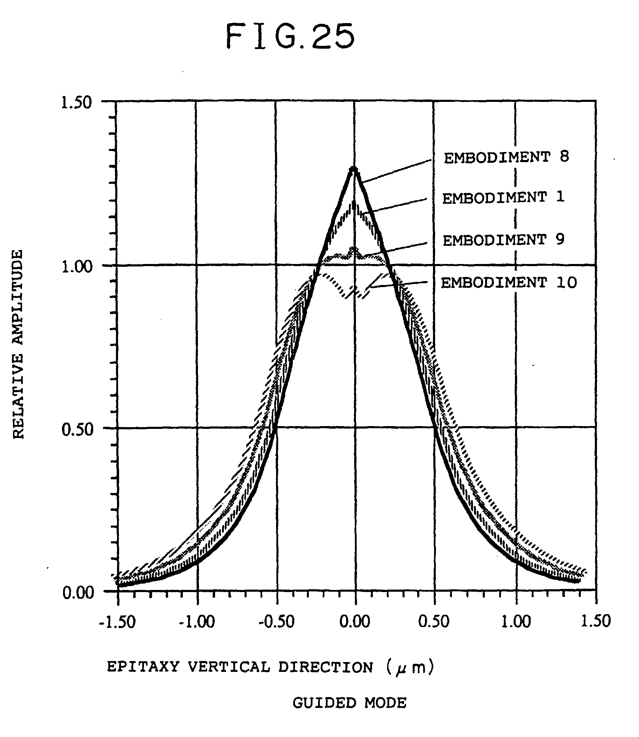

FIG. 25 is a graphic chart showing the guided mode characteristics in embodiments 1 and 8 ~ 10.

[FIG. 26]

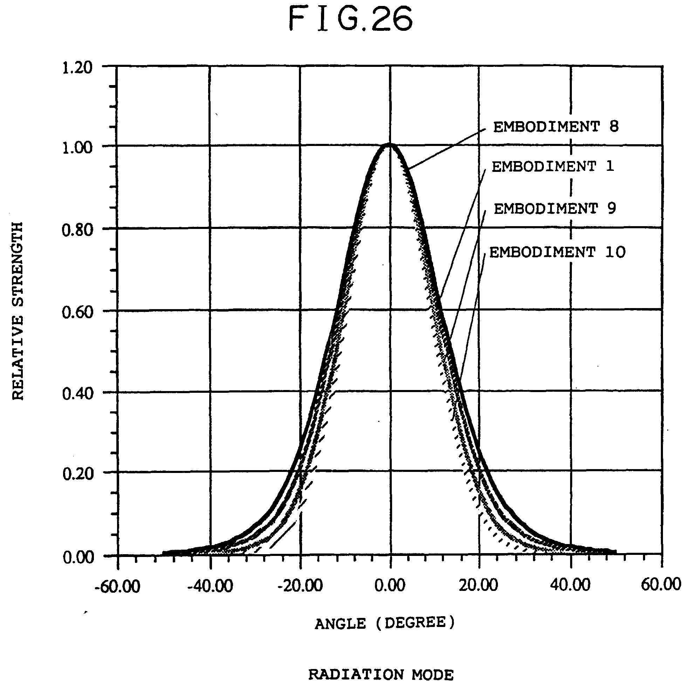

FIG. 26 is a graphic chart showing the characteristics of the radiation beam angle in the embodiments 1 and 8 ~ 10.

[FIG. 27]

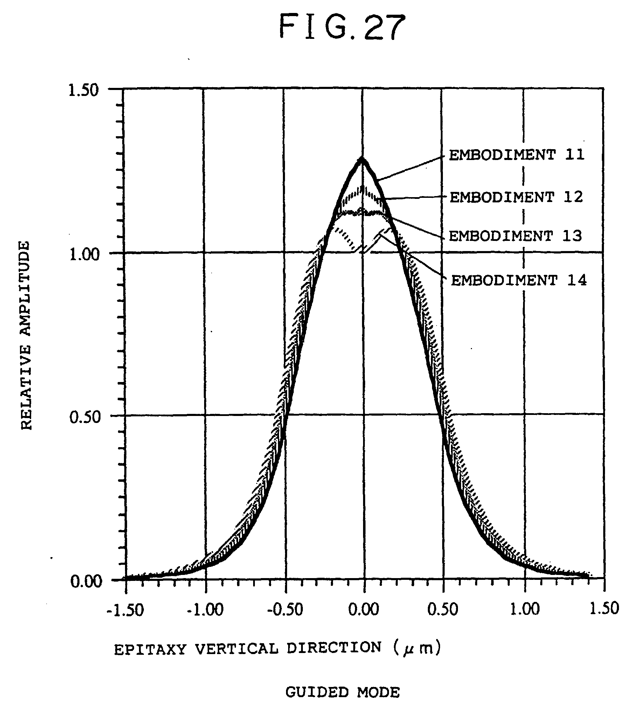

FIG. 27 is a graphic chart showing the guided mode characteristics in embodiments 11 ~ 14.

[FIG. 28]

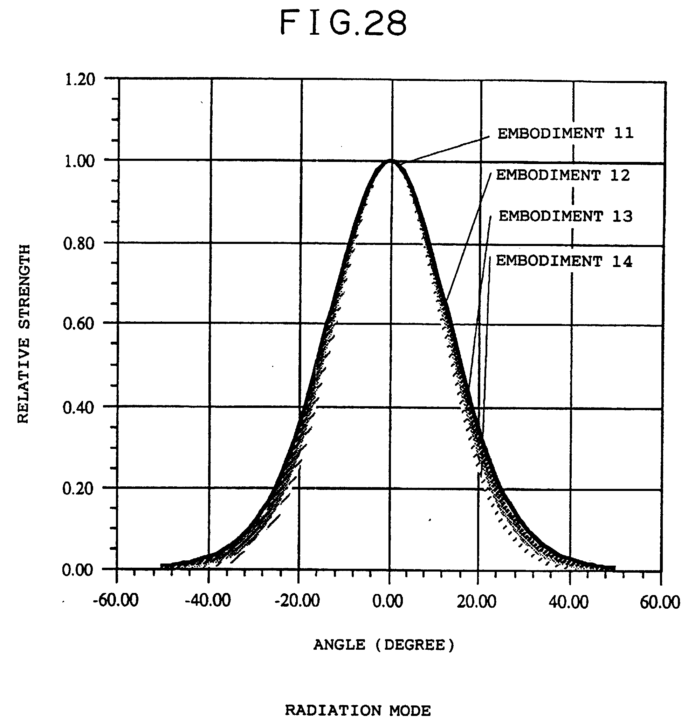

FIG. 28 is a graphic chart showing the characteristics of the radiation beam angle in the embodiments 11 ~ 14.

[FIG. 29]

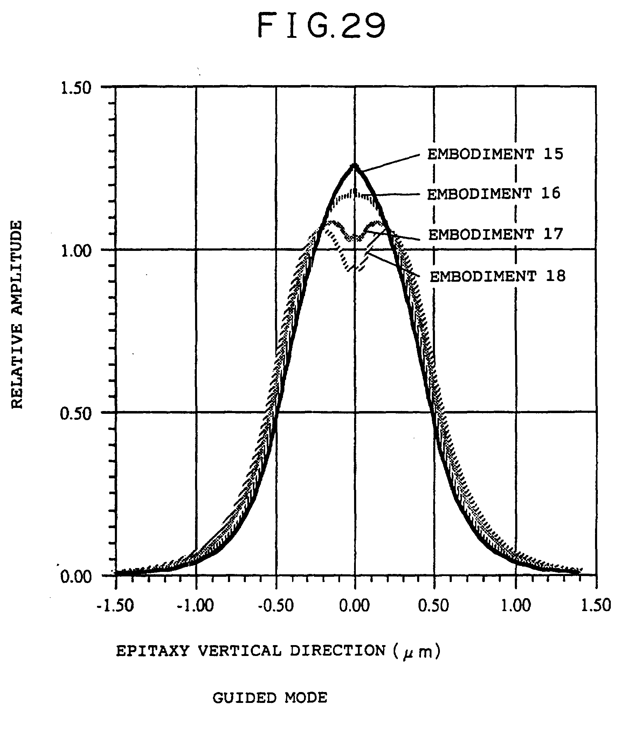

FIG. 29 is a graphic chart showing the guided mode characteristics in embodiments 15 ~ 18.

[FIG. 30]

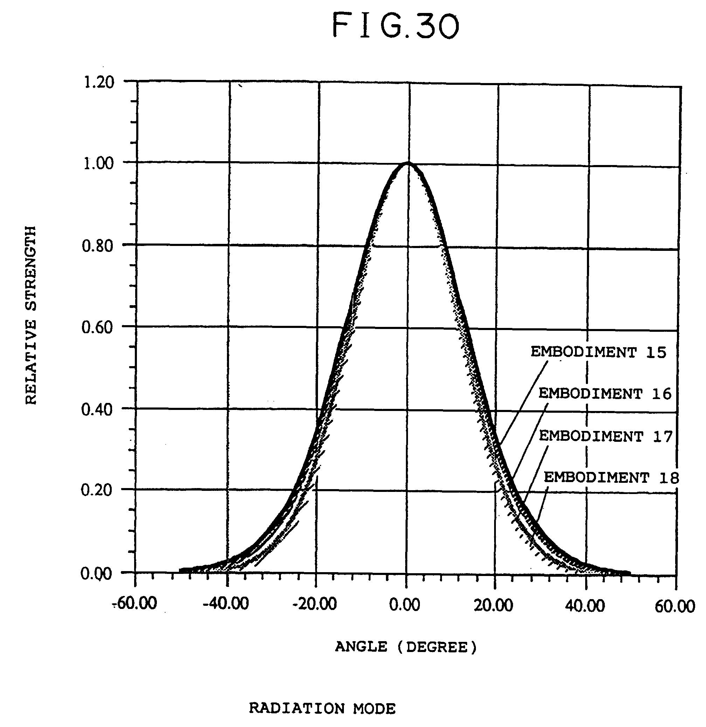

FIG. 30 is a graphic chart showing the characteristics of the radiation beam angle in the embodiments 15 ~ 18.

[FIG. 31]

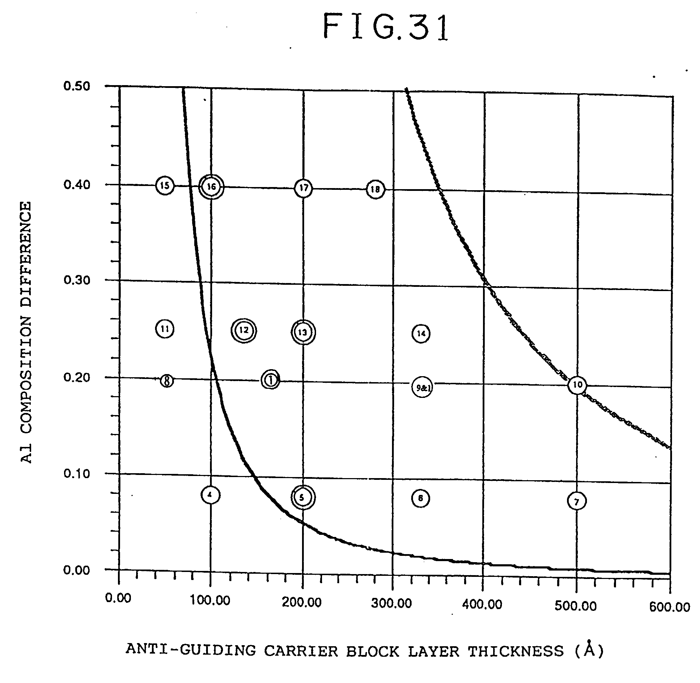

FIG. 31 is a graphic chart representing an effective range of a barrier layer.

[FIG. 32]

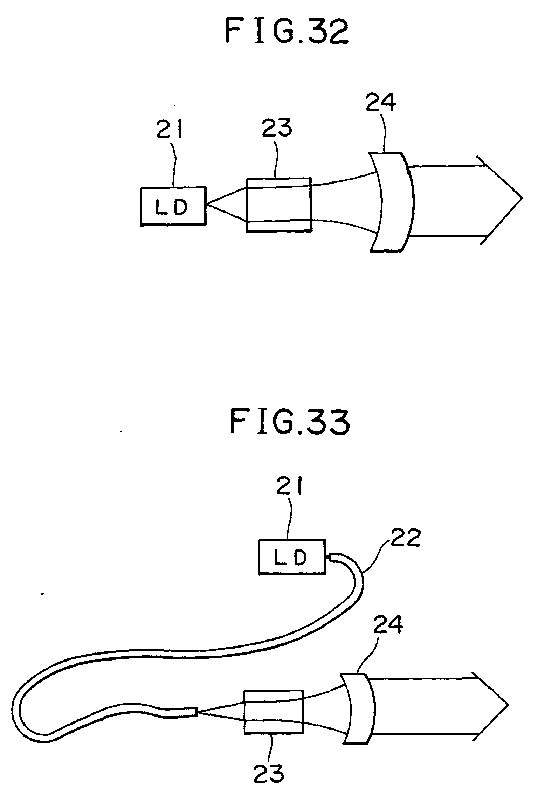

FIG. 32 is a view illustrating a direct-connection type semiconductor laser excitation solid-state laser device utilizing the laser element according to this invention.

[FIG. 33]

FIG. 33 is a view illustrating an example of a fiber connection type semiconductor laser excitation solid-state state laser device utilizing the laser element according to this invention.

Best Mode For Carrying Out The Invention

The present invention will hereinafter be described on the basis of the drawings.

Epitaxial growths exhibiting profiles illustrated in FIGS. 2 ~ 20 are performed by MOCVD growth. FIG. 2 shows an embodiment 1. FIG. 3 shows an embodiment 2. FIG. 4 shows an embodiment 3. FIG. 5 shows an embodiment 4. FIG. 6 shows an embodiment 5. FIG. 7 shows an embodiment 6. FIG. 8 shows an embodiment 7. FIG. 9 shows an embodiment 8. FIG. 10 shows an embodiment 9. FIG. 11 shows an embodiment 10. FIG. 12 shows an embodiment 11. FIG. 13 shows an embodiment 12. FIG. 14 shows an embodiment 13. FIG. 15 shows an embodiment 14. FIG. 16 shows in an embodiment 15. FIG. 17 shows an embodiment 16. FIG. 18 shows an embodiment 17. FIG. 19 shows an embodiment 18. FIG. 20 is a schematic plan view thereof in a comparative example. FIG. 21 is a graphic chart showing a guided mode in the embodiments 1 ~ 3 and the comparative example. FIG. 22 is a graphic chart showing a radiation mode in the embodiments 1 ~ 3 and the comparative example. FIG. 23 is a graphic chart showing a guided mode in the embodiments 4 ~ 7. FIG. 24 is a graphic chart showing a radiation mode in the embodiment 4 ~ 7. FIG. 25 is a graphic chart showing a guided mode in the embodiments 1 and 8 ~ 10. FIG. 26 is a graphic chart showing a radiation mode in the embodiments 1 and 8 ~ 10. FIG. 27 is a graphic chart showing a guided mode in the embodiments 11 ~ 14. FIG. 28 is a graphic chart showing a radiation mode in the embodiments 11 ~ 14. FIG. 29 is a graphic chart showing a guided mode in the embodiments 15 ~ 18. FIG. 30 is a graphic chart showing a radiation mode in the embodiments 15 ~ 18. FIG. 31 is a graphic chart representing an effective range of a carrier block layers, wherein the axis of abscissa indicates a difference in Al composition, and the axis of ordinate indicates a thickness of the carrier block layers.

In FIG. 31, the anti-guiding function of the carrier block layers is too large, and therefore a reentrant is formed in the vicinity of the active layer in the guided mode in an upper range from the right upper curve. Concretely, a reentrant is formed in the guided mode in the vicinity of the active layer. This brings about a decrease in the optical confinement factor, resulting in an increment in threshold current. Further, it follows that the guided mode deviates largely from the Gaussian mode, and an aberration is caused in the radiation pattern. The carrier confinement is insufficient enough to worsen a temperature characteristic of the threshold current in a lower range from the left lower curve. The guiding function of the active layer is compensated most optimally by the carrier block layers to exhibit the best guided mode in a range where the following relationship is established:

$$V_0 / 3 < V_1 < V_0$$

The embodiments falling within this range are marked with ⊙. (1) Represents the embodiment 1, and (2) indicates the embodiment 2. The circled numerals in the same Figure (FIG. 31) hereinafter similarly represent the embodiments corresponding to the numerals.

An effective range (exhibiting the effects) in the present invention is defined by the two solid lines.

The following is a technology common to the respective embodiment. Doping on the order of $1 \times 10^{18}/cm^3$ is conducted by use of Se as an n-type dopant and Zn as a p-type dopant. Zinc is diffused in a striped shape from the surface by use of an $SiO_2$ diffusion mask. Thereafter, a trail manufacture of a diode chip having a gain guiding structure is conducted by effecting a cleavage. After performing die-bonding to an LD mount, an light-current characteristic is measured in a pulse mode. Table 1 shows characteristic of the typical chip having stripe width of 2,5 pm and a cavity length of 300 pm. Note that no optical coating is applied to both edge surfaces.

(Embodiment 1)

As illustrated in FIG. 2, an n-type buffer layer 10 having a thickness of 0.5 μm is formed on an n-type substrate 8 composed of GaAs. Formed sequentially on this layer are an n-type clad layer 1, an n-type light wave guide layer 2, an n-type carrier block layer 3, an active layer 4, a p-type carrier block layer 5, a p-type light wave guide layer 6 and a p-type clad layer 7. An n-type cap layer 11 is formed as an uppermost layer thereon.

The following are concrete configurations of the respective layers.

n-type cap layer 11
    Thickness: 0.3 μm
    Composition: GaAs
p-type clad layer 7
    Thickness: 1.0 μm
    Composition: $Al_{0.35}Ga_{0.65}As$
p-type light wave guide layer 6
    Thickness: 0.46 μm
    Composition: $Al_{0.30}Ga_{0.70}As$
n-type light wave guide layer 2
    Thickness: 0.46 μm
    Composition: $Al_{0.30}Ga_{0.70}As$
n-type clad layer 1
    Thickness: 1.0 μm
    Composition: $Al_{0.35}Ga_{0.65}As$
n-type buffer layer 10
    Thickness: 0.5 μm
    Composition: GaAs
n-type substrate 8
    Composition: (100) GaAs

The active layer 4 is formed such that 4-layered quantum well layers 13 are each partitioned by barrier layers 14 between side barrier layers 12 deposited on inner walls of the respective carrier block layers 5, 3 in an area sandwiched in between the p-type carrier block layer 5 and the n-type carrier block layer 3. The concrete configurations of this active layer 4 are given as follows:

p-type carrier block layer 5
    Thickness: 165 angstrom
    Composition: $Al_{0.50}Ga_{0.50}As$
Side barrier layer 12
    Thickness: 25 angstrom
    Composition: $Al_{0.30}Ga_{0.70}As$
Quantum well layer 13
    Thickness: 55 angstrom
    Composition: GaAs
Barrier layer 14
    Thickness: 50 angstrom
    Composition: $Al_{0.30}Ga_{0.70}As$
n-type carrier block layer 3
    Thickness: 165 angstrom
    Composition: $Al_{0.50}Ga_{0.50}As$

FIG. 21 illustrates a guided mode profile (near-field patterns) in the direction vertical to the epitaxy layer with respect to the structure shown in this embodiment. FIG. 22 shows a measured result in the radiation mode.

(Embodiment 2)

As illustrated in FIG. 3, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

9

n-type cap layer 11
    Thickness: 0.3 μm
    Composition: GaAs
p-type clad layer 7
    Thickness: 2.0 μm
    Composition: $Al_{0.31}Ga_{0.69}As$
p-type light wave guide layer 6
    Thickness: 0.93 μm
    Composition: $Al_{0.30}Ga_{0.70}As$
n-type light wave guide layer 2
    Thickness: 0.93 μm
    Composition: $Al_{0.30}Ga_{0.70}As$
n-type clad layer 1
    Thickness: 2.0 μm
    Composition: $Al_{0.31}Ga_{0.69}As$
n-type buffer layer 10
    Thickness: 0.5 μm
    Composition: GaAs
n-type substrate 8
    Composition: (100) GaAs

The active layer 4 is formed such that 8-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type barrier layer 3. The concrete configurations of this active layer 4 are given as follows:

p-type carrier block layer 5
    Thickness: 330 angstrom
    Composition: $Al_{0.50}Ga_{0.50}As$
Side barrier layer 12
    Thickness: 25 angstrom
    Composition: $Al_{0.30}Ga_{0.70}As$
Quantum well layer 13
    Thickness: 55 angstrom
    Composition: GaAs
Barrier layer 14
    Thickness: 50 angstrom
    Composition: $Al_{0.30}Ga_{0.70}As$
n-type carrier block layer 3
    Thickness: 330 angstrom
    Composition: $Al_{0.50}Ga_{0.50}As$

FIG. 21 illustrates a guided mode profile (near-field pattern) in the direction vertical to the epitaxy layer with respect to the structure shown in this embodiment. FIG. 22 shows a measured result in the radiation mode.

(Embodiment 3)

As illustrated in FIG. 4, an n-type inversion layer 15 is provided between the p-type clad layer 7 and the p-type light wave guide layer 6. With the placement of this n-type inversion layer, the current can be narrowed down in the lateral direction in the vicinity of the active layer 4.

Namely, the light is confined also in the lateral direction owing to the n-type inversion layer 15, thereby making it possible to attain a stabilized off-axial mode. n-type cap layer 11
    Thickness: 0.3 μm
    Composition: GaAs
p-type clad layer 7
    Thickness: 0.8 μm
    Composition: $Al_{0.35}Ga_{0.65}As$
n-type inversion layer 15
    Thickness: 0.2 μm
    Composition: $Al_{0.35}Ga_{0.65}As$
p-type light wave guide layer 6

Thickness: 0.93 μm
Composition: $Al_{0.30}Ga_{0.70}As$
n-type light wave guide layer 2
Thickness: 0.93 μm
Composition: $Al_{0.30}Ga_{0.70}As$
n-type clad layer 1
Thickness: 1.0 μm
Composition: $Al_{0.35}Ga_{0.65}As$
n-type buffer layer 10
Thickness: 0.5 μm
Composition: GaAs
n-type substrate 8
Composition: (100) GaAs

The active layer 4 is formed such that the 8-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:
p-type carrier block layer 5
Thickness: 330 angstrom
Composition: $Al_{0.50}Ga_{0.50}As$
Side barrier layer 12
Thickness: 25 angstrom
Composition: $Al_{0.30}Ga_{0.70}As$
Quantum well layer 13
Thickness: 55 angstrom
Composition: GaAs
Barrier layer 14
Thickness: 50 angstrom
Composition: $Al_{0.30}Ga_{0.70}As$
n-type carrier block layer 3
Thickness: 330 angstrom
Composition: $Al_{0.50}Ga_{0.50}As$

FIG. 21 illustrates a guided mode profile (near-field pattern) in the direction vertical to the epitaxy layer with respect to the structure shown in this embodiment. FIG. 22 shows a measured result in the radiation mode.

(Embodiment 4)

As illustrated in FIG. 5, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.
n-type cap layer 11
Thickness: 0.3 μm
Composition: GaAs
p-type clad layer 7
Thickness: 1.0 μm
Composition: $Al_{0.35}Ga_{0.65}As$
p-type light wave guide layer 6
Thickness: 0.46 μm
Composition: $Al_{0.30}Ga_{0.70}As$
n-type light wave guide layer 2
Thickness: 0.46 μm
Composition: $Al_{0.30}Ga_{0.70}As$
n-type clad layer 1
Thickness: 1.0 μm
Composition: $Al_{0.35}Ga_{0.65}As$
n-type buffer layer 10

Thickness: 0.5 µm

Composition: GaAs

n-type substrate 8

Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5

Thickness: 100 angstrom

Composition: $Al_{0.38}Ga_{0.62}As$

Side barrier layer 12

Thickness: 25 angstrom

Composition: $Al_{0.30}Ga_{0.70}As$

Quantum well layer 13

Thickness: 55 angstrom

Composition: GaAs

Barrier layer 14

Thickness: 50 angstrom

Composition: $Al_{0.30}Ga_{0.70}As$

n-type carrier block layer 3

Thickness: 100 angstrom

Composition: $Al_{0.38}Ga_{0.62}As$

FIG. 23 illustrates a guided mode profile (near-field pattern) in the direction vertical to the epitaxy layer with respect to the structure shown in this embodiment. FIG. 24 shows a measured result in the radiation mode.

(Embodiment 5)

As illustrated in FIG. 6, the n-type buffer layer 10 having a thickness of 0.5 µm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11

Thickness: 0.3 µm

Composition: GaAs

p-type clad layer 7

Thickness: 1.0 µm

Composition: $Al_{0.35}Ga_{0.65}As$

p-type light wave guide layer 6

Thickness: 0.46 µm

Composition: $Al_{0.30}Ga_{0.70}As$

n-type light wave guide layer 2

Thickness: 0.46 µm

Composition: $Al_{0.30}Ga_{0.70}As$

n-type clad layer 1

Thickness: 1.0 µm

Composition: $Al_{0.35}Ga_{0.65}As$

n-type buffer layer 10

Thickness: 0.5 µm

Composition: GaAs

n-type substrate 8

Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5

Thickness: 200 angstrom

Composition: $Al_{0.38}Ga_{0.62}As$

Side barrier layer 12

Thickness: 25 angstrom

Composition: $Al_{0.30}Ga_{0.70}As$

Quantum well layer 13

Thickness: 55 angstrom

Composition: GaAs

Barrier layer 14

Thickness: 50 angstrom

Composition: $Al_{0.30}Ga_{0.70}As$

n-type carrier block layer 3

Thickness: 200 angstrom

Composition: $Al_{0.38}Ga_{0.62}As$

FIG. 23 illustrates a guided mode profile (near-field pattern) in the direction vertical to the epitaxy layer with respect to the structure shown in this embodiment. FIG. 24 shows a measured result in the radiation mode.

(Embodiment 6)

As illustrated in FIG. 7, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11

Thickness: 0.3 μm

Composition: GaAs

p-type clad layer 7

Thickness: 1.0 μm

Composition: $Al_{0.35}Ga_{0.65}As$

p-type light wave guide layer 6

Thickness: 0.46 μm

Composition: $Al_{0.30}Ga_{0.70}As$

n-type light wave guide layer 2

Thickness: 0.46 μm

Composition: $Al_{0.30}Ga_{0.70}As$

n-type clad layer 1

Thickness: 1.0 μm

Composition: $Al_{0.35}Ga_{0.65}As$

n-type buffer layer 10

Thickness: 0.5 μm

Composition: GaAs

n-type substrate 8

Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5

Thickness: 330 angstrom

Composition: $Al_{0.38}Ga_{0.62}As$

Side barrier layer 12

Thickness: 25 angstrom

Composition: $Al_{0.30}Ga_{0.70}As$

Quantum well layer 13

Thickness: 55 angstrom

Composition: GaAs

Barrier layer 14

Thickness: 50 angstrom
Composition: $Al_{0.30}Ga_{0.70}As$
n-type carrier block layer 3
Thickness: 330 angstrom
Composition: $Al_{0.38}Ga_{0.62}As$

FIG. 23 illustrates a guided mode profile (near-field pattern) in the direction vertical to the epitaxy layer with respect to the structure shown in this embodiment. FIG. 24 shows a measured result in the radiation mode.

(Embodiment 7)

As illustrated in FIG. 8, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.
n-type cap layer 11
Thickness: 0.3 μm
Composition: GaAs
p-type clad layer 7
Thickness: 1.0 μm
Composition: $Al_{0.35}Ga_{0.65}As$
p-type light wave guide layer 6
Thickness: 0.46 μm
Composition: $Al_{0.30}Ga_{0.70}As$
n-type light wave guide layer 2
Thickness: 0.46 μm
Composition: $Al_{0.30}Ga_{0.70}As$
n-type clad layer 1
Thickness: 1.0 μm
Composition: $Al_{0.35}Ga_{0.65}As$
n-type buffer layer 10
Thickness: 0.5 μm
Composition: GaAs
n-type substrate 8
Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:
p-type carrier block layer 5
Thickness: 500 angstrom
Composition: $Al_{0.38}Ga_{0.62}As$
Side barrier layer 12
Thickness: 25 angstrom
Composition: $Al_{0.30}Ga_{0.70}As$
Quantum well layer 13
Thickness: 55 angstrom
Composition: GaAs
Barrier layer 14
Thickness: 50 angstrom
Composition: $Al_{0.30}Ga_{0.70}As$
n-type carrier block layer 3
Thickness: 500 angstrom
Composition: $Al_{0.38}Ga_{0.62}As$

FIG. 23 illustrates a guided mode profile (near-field pattern) in the direction vertical to the epitaxy layer with respect to the structure shown in this embodiment. FIG. 24 shows a measured result in the radiation mode.

(Embodiment 8)

As illustrated in FIG. 9, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
    Thickness: 0.3 μm
    Composition: GaAs

p-type clad layer 7
    Thickness: 1.0 μm
    Composition: $Al_{0.35}Ga_{0.65}As$

p-type light wave guide layer 6
    Thickness: 0.46 μm
    Composition: $Al_{0.30}Ga_{0.70}As$

n-type light wave guide layer 2
    Thickness: 0.46 μm
    Composition: $Al_{0.30}Ga_{0.70}As$

n-type clad layer 1
    Thickness: 1.0 μm
    Composition: $Al_{0.35}Ga_{0.65}As$

n-type buffer layer 10
    Thickness: 0.5 μm
    Composition: GaAs

n-type substrate 8
    Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type barrier layer 5
    Thickness: 50 angstrom
    Composition: $Al_{0.50}Ga_{0.50}As$

Side barrier layer 12
    Thickness: 25 angstrom
    Composition: $Al_{0.30}Ga_{0.70}As$

Quantum well layer 13
    Thickness: 55 angstrom
    Composition: GaAs

Barrier layer 14
    Thickness: 50 angstrom
    Composition: $Al_{0.30}Ga_{0.70}As$

n-type carrier block layer 3
    Thickness: 50 angstrom
    Composition: $Al_{0.50}Ga_{0.50}As$

FIG. 25 illustrates a guided mode profile (near-field pattern) in the direction vertical to the epitaxy layer with respect to the structure shown in this embodiment. FIG. 26 shows a measured result in the radiation mode.

(Embodiment 9)

As illustrated in FIG. 10, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
    Thickness: 0.3 μm

Composition: GaAs
p-type clad layer 7
    Thickness: 1.0 µm
    Composition: $Al_{0.35}Ga_{0.65}As$
p-type light wave guide layer 6
    Thickness: 0.46 µm
    Composition: $Al_{0.30}Ga_{0.70}As$
n-type light wave guide layer 2
    Thickness: 0.46 µm
    Composition: $Al_{0.30}Ga_{0.70}As$
n-type clad layer 1
    Thickness: 1.0 µm
    Composition: $Al_{0.35}Ga_{0.65}As$
n-type buffer layer 10
    Thickness: 0.5 µm
    Composition: GaAs
n-type substrate 8
    Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
    Thickness: 330 angstrom
    Composition: $Al_{0.50}Ga_{0.50}As$
Side barrier layer 12
    Thickness: 25 angstrom
    Composition: $Al_{0.30}Ga_{0.70}As$
Quantum well layer 13
    Thickness: 55 angstrom
    Composition: GaAs
Barrier layer 14
    Thickness: 50 angstrom
    Composition: $Al_{0.30}Ga_{0.70}As$
n-type carrier block layer 3
    Thickness: 330 angstrom
    Composition: $Al_{0.50}Ga_{0.50}As$

FIG. 25 illustrates a guided mode profile (near-field pattern) in the direction vertical to the epitaxy layer with respect to the structure shown in this embodiment. FIG. 26 shows a measured result in the radiation mode.

(Embodiment 10)

As illustrated in FIG. 11, the n-type buffer layer 10 having a thickness of 0.5 µm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
    Thickness: 0.3 µm
    Composition: GaAs
p-type clad layer 7
    Thickness: 1.0 µm
    Composition: $Al_{0.35}Ga_{0.65}As$
p-type light wave guide layer 6
    Thickness: 0.46 µm
    Composition: $Al_{0.30}Ga_{0.70}As$
n-type light wave guide layer 2
    Thickness: 0.46 µm

Composition: $Al_{0.30}Ga_{0.70}As$
n-type clad layer 1
    Thickness: 1.0 μm
    Composition: $Al_{0.35}Ga_{0.65}As$
n-type buffer layer 10
    Thickness: 0.5 μm
    Composition: GaAs
n-type substrate 8
    Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
    Thickness: 500 angstrom
    Composition: $Al_{0.50}Ga_{0.50}As$
Side barrier layer 12
    Thickness: 25 angstrom
    Composition: $Al_{0.30}Ga_{0.70}As$
Quantum well layer 13
    Thickness: 55 angstrom
    Composition: GaAs
Barrier layer 14
    Thickness: 50 angstrom
    Composition: $Al_{0.30}Ga_{0.70}As$
n-type barrier layer 3
    Thickness: 500 angstrom
    Composition: $Al_{0.50}Ga_{0.50}As$

FIG. 25 illustrates a guided mode profile (near-field pattern) in the direction vertical to the epitaxy layer with respect to the structure shown in this embodiment. FIG. 26 shows a measured result in the radiation mode.

(Embodiment 11)

As illustrated in FIG. 12, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
    Thickness: 0.3 μm
    Composition: GaAs
p-type clad layer 7
    Thickness: 1.0 μm
    Composition: $Al_{0.35}Ga_{0.65}As$
p-type light wave guide layer 6
    Thickness: 0.46 μm
    Composition: $Al_{0.25}Ga_{0.75}As$
n-type light wave guide layer 2
    Thickness: 0.46 μm
    Composition: $Al_{0.25}Ga_{0.75}As$
n-type clad layer 1
    Thickness: 1.0 μm
    Composition: $Al_{0.35}Ga_{0.65}As$
n-type buffer layer 10
    Thickness: 0.5 μm
    Composition: GaAs
n-type substrate 8
    Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
      Thickness: 50 angstrom
      Composition: $Al_{0.50}Ga_{0.50}As$
Side barrier layer 12
      Thickness: 25 angstrom
      Composition: $Al_{0.25}Ga_{0.75}As$
Quantum well layer 13
      Thickness: 55 angstrom
      Composition: GaAs
Barrier layer 14
      Thickness: 50 angstrom
      Composition: $Al_{0.25}Ga_{0.75}As$
n-type carrier block layer 3
      Thickness: 50 angstrom
      Composition: $Al_{0.50}Ga_{0.50}As$

FIG. 27 illustrates a guided mode profile (near-field pattern) in the direction vertical to the epitaxy layer with respect to the structure shown in this embodiment. FIG. 28 shows a measured result in the radiation mode.

(Embodiment 12)

As illustrated in FIG. 13, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
      Thickness: 0.3 μm
      Composition: GaAs
p-type clad layer 7
      Thickness: 1.0 μm
      Composition: $Al_{0.35}Ga_{0.65}As$
p-type light wave guide layer 6
      Thickness: 0.46 μm
      Composition: $Al_{0.25}Ga_{0.75}As$
n-type light wave guide layer 2
      Thickness: 0.46 μm
      Composition: $Al_{0.25}Ga_{0.75}As$
n-type clad layer 1
      Thickness: 1.0 μm
      Composition: $Al_{0.35}Ga_{0.65}As$
n-type buffer layer 10
      Thickness: 0.5 μm
      Composition: GaAs
n-type substrate 8
      Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
      Thickness: 135 angstrom
      Composition: $Al_{0.50}Ga_{0.50}As$
Side barrier layer 12
      Thickness: 25 angstrom

Composition: $Al_{0.25}Ga_{0.75}As$
Quantum well layer 13
Thickness: 55 angstrom
Composition: GaAs
Barrier layer 14
Thickness: 50 angstrom
Composition: $Al_{0.25}Ga_{0.75}As$
n-type carrier block layer 3
Thickness: 135 angstrom
Composition: $Al_{0.50}Ga_{0.50}As$

FIG. 27 illustrates a guided mode profile (near-field pattern) in the direction vertical to the epitaxy layer with respect to the structure shown in this embodiment. FIG. 28 shows a measured result in the radiation mode.

(Embodiment 13)

As illustrated in FIG. 14, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.
n-type cap layer 11
Thickness: 0.3 μm
Composition: GaAs
p-type clad layer 7
Thickness: 1.0 μm
Composition: $Al_{0.35}Ga_{0.65}As$
p-type light wave guide layer 6
Thickness: 0.46 μm
Composition: $Al_{0.25}Ga_{0.75}As$
n-type light wave guide layer 2
Thickness: 0.46 μm
Composition: $Al_{0.25}Ga_{0.75}As$
n-type clad layer 1
Thickness: 1.0 μm
Composition: $Al_{0.35}Ga_{0.65}As$
n-type buffer layer 10
Thickness: 0.5 μm
Composition: GaAs
n-type substrate 8
Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:
p-type carrier block layer 5
Thickness: 200 angstrom
Composition: $Al_{0.50}Ga_{0.50}As$
Side barrier layer 12
Thickness: 25 angstrom
Composition: $Al_{0.25}Ga_{0.75}As$
Quantum well layer 13
Thickness: 55 angstrom
Composition: GaAs
Barrier layer 14
Thickness: 50 angstrom
Composition: $Al_{0.25}Ga_{0.75}As$
n-type carrier block layer 3
Thickness: 200 angstrom

Composition: $Al_{0.50}Ga_{0.50}As$

FIG. 27 illustrates a guided mode profile (near-field pattern) in the direction vertical to the epitaxy layer with respect to the structure shown in this embodiment. FIG. 28 shows a measured result in the radiation mode.

(Embodiment 14)

As illustrated in FIG. 15, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
  Thickness: 0.3 μm
  Composition: GaAs

p-type clad layer 7
  Thickness: 1.0 μm
  Composition: $Al_{0.35}Ga_{0.65}As$

p-type light wave guide layer 6
  Thickness: 0.46 μm
  Composition: $Al_{0.25}Ga_{0.75}As$

n-type light wave guide layer 2
  Thickness: 0.46 μm
  Composition: $Al_{0.25}Ga_{0.75}As$

n-type clad layer 1
  Thickness: 1.0 μm
  Composition: $Al_{0.35}Ga_{0.65}As$

n-type buffer layer 10
  Thickness: 0.5 μm
  Composition: GaAs

n-type substrate 8
  Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
  Thickness: 330 angstrom
  Composition: $Al_{0.50}Ga_{0.50}As$

Side barrier layer 12
  Thickness: 25 angstrom
  Composition: $Al_{0.25}Ga_{0.75}As$

Quantum well layer 13
  Thickness: 55 angstrom
  Composition: GaAs

Barrier layer 14
  Thickness: 50 angstrom
  Composition: $Al_{0.25}Ga_{0.75}As$

n-type carrier block layer 3
  Thickness: 330 angstrom
  Composition: $Al_{0.50}Ga_{0.50}As$

FIG. 27 illustrates a guided mode profile (near-field pattern) in the direction vertical to the epitaxy layer with respect to the structure shown in this embodiment. FIG. 28 shows a measured result in the radiation mode.

(Embodiment 15)

As illustrated in FIG. 16, the n-type buffer layer 10 having a thickness of 0.5 μm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
    Thickness: 0.3 $\mu$m
    Composition: GaAs
p-type clad layer 7
    Thickness: 1.0 $\mu$m
    Composition: $Al_{0.35}Ga_{0.65}As$
p-type light wave guide layer 6
    Thickness: 0.46 $\mu$m
    Composition: $Al_{0.25}Ga_{0.75}As$
n-type light wave guide layer 2
    Thickness: 0.46 $\mu$m
    Composition: $Al_{0.25}Ga_{0.75}As$
n-type clad layer 1
    Thickness: 1.0 $\mu$m
    Composition: $Al_{0.35}Ga_{0.65}As$
n-type buffer layer 10
    Thickness: 0.5 $\mu$m
    Composition: GaAs
n-type substrate 8
    Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
    Thickness: 50 angstrom
    Composition: $Al_{0.65}Ga_{0.35}As$
Side barrier layer 12
    Thickness: 25 angstrom
    Composition: $Al_{0.25}Ga_{0.75}As$
Quantum well layer 13
    Thickness: 55 angstrom
    Composition: GaAs
Barrier layer 14
    Thickness: 50 angstrom
    Composition: $Al_{0.25}Ga_{0.75}As$
n-type carrier block layer 3
    Thickness: 50 angstrom
    Composition: $Al_{0.65}Ga_{0.35}As$

FIG. 29 illustrates a guided mode profile (near-field pattern) in the direction vertical to the epitaxy layer with respect to the structure shown in this embodiment. FIG. 30 shows a measured result in the radiation mode.

(Embodiment 16)

As illustrated in FIG. 17, the n-type buffer layer 10 having a thickness of 0.5 $\mu$m is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.

n-type cap layer 11
    Thickness: 0.3 $\mu$m
    Composition: GaAs
p-type clad layer 7
    Thickness: 1.0 $\mu$m
    Composition: $Al_{0.35}Ga_{0.65}As$
p-type light wave guide layer 6

  Thickness: 0.46 µm
  Composition: $Al_{0.25}Ga_{0.75}As$
n-type light wave guide layer 2
  Thickness: 0.46 pm
  Composition: $Al_{0.25}Ga_{0.75}As$
n-type clad layer 1
  Thickness: 1.0 µm
  Composition: $Al_{0.35}Ga_{0.65}As$
n-type buffer layer 10
  Thickness: 0.5 µm
  Composition: GaAs
n-type substrate 8
  Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:

p-type carrier block layer 5
  Thickness: 100 angstrom
  Composition: $Al_{0.65}Ga_{0.35}As$
Side barrier layer 12
  Thickness: 25 angstrom
  Composition: $Al_{0.25}Ga_{0.75}As$
Quantum well layer 13
  Thickness: 55 angstrom
  Composition: GaAs
Barrier layer 14
  Thickness: 50 angstrom
  Composition: $Al_{0.25}Ga_{0.75}As$
n-type carrier block layer 3
  Thickness: 100 angstrom
  Composition: $Al_{0.65}Ga_{0.35}As$

FIG. 29 illustrates a guided mode profile (near-field pattern) in the direction vertical to the epitaxy layer with respect to the structure shown in this embodiment. FIG. 30 shows a measured result in the radiation mode.

(Embodiment 17)

As illustrated in FIG. 18, the n-type buffer layer 10 having a thickness of 0.5 µm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.

The following are concrete configurations of the respective layers.
n-type cap layer 11
  Thickness: 0.3 µm
  Composition: GaAs
p-type clad layer 7
  Thickness: 1.0 µm
  Composition: $Al_{0.35}Ga_{0.65}As$
p-type light wave guide layer 6
  Thickness: 0.46 µm
  Composition: $Al_{0.25}Ga_{0.75}As$
n-type light wave guide layer 2
  Thickness: 0.46 µm
  Composition: $Al_{0.25}Ga_{0.75}As$
n-type clad layer 1
  Thickness: 1.0 µm
  Composition: $Al_{0.35}Ga_{0.65}As$
n-type buffer layer 10

Thickness: 0.5 µm
Composition: GaAs
n-type substrate 8
Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:
p-type carrier block layer 5
    Thickness: 200 angstrom
    Composition: $Al_{0.65}Ga_{0.35}As$
Side barrier layer 12
    Thickness: 25 angstrom
    Composition: $Al_{0.25}Ga_{0.75}As$
Quantum well layer 13
    Thickness: 55 angstrom
    Composition: GaAs
Barrier layer 14
    Thickness: 50 angstrom
    Composition: $Al_{0.25}Ga_{0.75}As$
n-type carrier block layer 3
    Thickness: 200 angstrom
    Composition: $Al_{0.65}Ga_{0.35}As$

FIG. 29 illustrates a guided mode profile (near-field pattern) in the direction vertical to the epitaxy layer with respect to the structure shown in this embodiment. FIG. 30 shows a measured result in the radiation mode.

(Embodiment 18)

As illustrated in FIG. 19, the n-type buffer layer 10 having a thickness of 0.5 µm is formed on the n-type substrate 8 composed of GaAs. Formed sequentially on this layer are the n-type clad layer 1, the n-type light wave guide layer 2, the n-type carrier block layer 3, the active layer 4, the p-type carrier block layer 5, the p-type light wave guide layer 6 and the p-type clad layer 7. The n-type cap layer 11 is formed as an uppermost layer thereon.
The following are concrete configurations of the respective layers.
n-type cap layer 11
    Thickness: 0.3 µm
    Composition: GaAs
p-type clad layer 7
    Thickness: 1.0 µm
    Composition: $Al_{0.35}Ga_{0.65}As$
p-type light wave guide layer 6
    Thickness: 0.46 µm
    Composition: $Al_{0.25}Ga_{0.75}As$
n-type light wave guide layer 2
    Thickness: 0.46 µm
    Composition: $Al_{0.25}Ga_{0.75}As$
n-type clad layer 1
    Thickness: 1.0 µm
    Composition: $Al_{0.35}Ga_{0.65}As$
n-type buffer layer 10
    Thickness: 0.5 µm
    Composition: GaAs
n-type substrate 8
    Composition: (100) GaAs

The active layer 4 is formed such that the 4-layered quantum well layers 13 are each partitioned by the barrier layers 14 between the side barrier layers 12 deposited on the inner walls of the respective carrier block layers 5, 3 in the area sandwiched in between the p-type carrier block layer 5 and the n-type carrier block layer 3. The concrete configurations of this active layer 4 are given as follows:
p-type carrier block layer 5

Thickness: 280 angstrom

Composition: $Al_{0.65}Ga_{0.35}As$

Side barrier layer 12

Thickness: 25 angstrom

Composition: $Al_{0.25}Ga_{0.75}As$

Quantum well layer 13

Thickness: 55 angstrom

Composition: GaAs

Barrier layer 14

Thickness: 50 angstrom

Composition: $Al_{0.25}Ga_{0.75}As$

n-type carrier block layer 3

Thickness: 280 angstrom

Composition: $Al_{0.65}Ga_{0.35}As$

FIG. 29 illustrates a guided mode profile (near-field pattern) in the direction vertical to the epitaxy layer with respect to the structure shown in this embodiment. FIG. 30 shows a measured result in the radiation mode.

(Comparative Example)

FIG. 20 is a schematic plan view showing a composition of a quantum well type laser element based on a conventional structure which is manufactured for comparisons with the above-mentioned embodiments 1 ~ 18.
The following are concrete configurations of the respective layers.

n-type cap layer 11

Thickness: 0.3 μm

Composition: GaAs

p-type clad layer 7

Thickness: 1.5 μm

Composition: $Al_{0.65}Ga_{0.35}As$

n-type clad layer 1

Thickness: 1.5 μm

Composition: $Al_{0.65}Ga_{0.35}As$

n-type buffer layer 10

Thickness: 0.5 μm

Composition: GaAs

n-type substrate 8

Composition: (100) GaAs

An active layer 4 is formed such that 4-layered quantum well layers 13 are partitioned by barrier layers 14 in an area sandwiched in between side barrier layers 12. The concrete configurations of this active layer 4 are given as follows:

Side barrier layer 12

Thickness: 120 angstrom

Composition: $Al_{0.30}Ga_{0.70}As$

Quantum well layer 13

Thickness: 50 angstrom

Composition: GaAs

Barrier layer 14

Thickness: 50 angstrom

Composition: $Al_{0.30}Ga_{0.70}As$

FIG. 21 illustrates a guided mode profile (near-field pattern) in the direction vertical to the epitaxy layer with respect to the structure shown in this embodiment. FIG. 22 shows a measured result in the radiation mode.
As obvious from FIG. 21, the weakly guiding semiconductor laser exhibits a center-pointed characteristic curve having exponential function tails on both sides. In contrast, the embodiments 1 ~ 18 exhibit characteristic forms similar to a Gaussian beam. For this reason, in the case of using the semiconductor laser in the present embodiment, as shown in Fig. 21 there decreases the beam intensity in the active layer 4 (mode center) where an optical damage is caused even with a mode expansion to the same extent as that in the prior arts. As shown by the measured results in Table 1 which follows, a level of the optical damage can be remarkably raised. Namely, a reduction in radiation angle and a remarkable improvement in the level of the optical damage in the present embodiments 1 - 3 become more apparent than in the comparative example. Note that an emission wavelength (angstrom) of the laser is approximately 800 nm in Table 1. Further, the optical damage level and the slope efficiency are each optical outputs per edge surface.

TABLE 1

| LD TYPE | NORMALIZED FREQUENCY | RADIATION ANGLE $\theta\perp/\theta\parallel$ | OPTICAL DAMAGE (mW) | THRESHOLD CURRENT (mA) | SLOPE EFFICIENCY (mW/mA) |
|---|---|---|---|---|---|
| EMBODIMENT 1 | 1.6 | 25° | 250mW | 90mA | 0.5 |
| STRUCTURE IN FIG. 2 | | 5° | | | |
| EMBODIMENT 2 | 1.6 | 14° | 500mW | 300mA | 0.5 |
| STRUCTURE IN FIG. 3 | | 4° | | | |
| EMBODIMENT 3 | 3.5 | 18° | 400mW | 250mA | 0.5 |
| STRUCTURE IN FIG. 4 | | 5° | | | |
| COMPARATIVE EXAMPLE | 0.28 | 22° | 100mW | 75mA | 0.4 |
| STRUCTURE IN FIG. 20 | | 8° | | | |

Industrial Applicability

In the industrial fields where the high-output semiconductor laser is employed for communications, optical recording on optical disks or the like, laser printers, laser medical treatments and laser machining, etc. according to the present invention, the high-efficiency semiconductor laser exhibiting a good beam profile at the low radiation beam angle can be obtained. Besides, it is possible to manufacture the high-output semiconductor laser by avoiding the concurrent optical damage of the edge surface with a simple structure. Especially in the $Al_xGa_{1-x}As$ semiconductor laser, the Al composition of the wave guide layer can be reduced, thereby facilitating the manufacturing process.

For this reason, the element of the present invention can be utilized in the form of the high-efficiency semiconductor laser device. Furthermore, the semiconductor laser can be used as an excitation source of a solid-state laser. The solid-state laser may involve the use of laser mediums such as Nd:YAG and Nd:YLF. If the semiconductor laser is employed as an excitation source of the solid-state laser, the problem is a method of connecting the semiconductor laser to the laser medium. Generally, excitation beams from the semiconductor laser are focused at a high efficiency through such a lens as to mode-match an excitation volume of the semiconductor laser with a mode volume of the laser oscillator.

In the laser element according to this invention, the beams may be focused by use of the lens as described above. As illustrated in FIGS. 32 and 33, the excitation beams from a semiconductor laser element 21 can be made to strike on a laser medium 23 without effecting any optical processing on the excitation beams from the semiconductor laser element 21. Incidentally, the numeral 24 designates an output mirror. Note that FIG. 32 shows a direct-connection type wherein the semiconductor laser element 21 is connected directly to the laser medium 23, while FIG. 33 illustrates a fiber connection type semiconductor laser excitation solid-state laser device in which the semiconductor laser element 21 is connected via an optical fiber 22 to the laser medium 23.

**Claims**

1.   A semiconductor laser element, comprising:

a) an active layer (4, 12, 13, 14) having a light guiding function;

b) carrier block layers (3, 5) formed bilaterally externally of said active layer (4), having a wide band gap sufficient to effect a carrier confinement in said active layer (4), being formed in a vertical direction from the surface of said element and reducing the light guiding function of said active layer (4);

c) waveguide layers (2, 6) provided bilaterally externally of said carrier block layers (3, 5); and

d) clad layers (1, 7) provided so that said wave guide layers (2, 6) are sandwiched therebetween;

***characterized in that***

e) $V_1$, $V_2$ are the normalized frequencies V of a mode in the carrier block layers (3, 5) and the clad layers (1, 7), respectively:

$$V_1 = \pi \cdot d_1 \, / \, \lambda \cdot ( \, N_0^2 - N_2^2 \, )^{0.5}$$

$$V_2 = \pi \cdot d_2 \, / \, \lambda \cdot ( \, N_0^2 - N_3^2 \, )^{0.5}$$

where $\pi$ is the ratio of the circumference of a circle to its diameter, $d_1$ is the thickness of said carrier block layer, $d_2$ is the thickness between said two clad layers, $\lambda$ is the oscillation wavelength, $N_0$ is the refractive index of said wave guide layer or the maximum thereof, if the refractive index of said wave guide layer continuously changes, $N_2$ is the refractive index of said carrier block layer, and $N_3$ is the refractive index of said clad layer, and then a relationship of $V_1 < V_2 \, / \, 10$ is established.

2. A semiconductor laser element according to claim 1, characterized in that furthermore a relationship of

$$\pi/2 < V_2 < 3.5$$

is established.

3. A semiconductor laser element according to claim 1, characterized in that the normalized frequency $V_0$ of amode in the active layer is given by

$$V_0 = \pi \cdot d_0 \, / \, \lambda \cdot ( \, N_1^2 - N_0^2 \, )^{0.5}$$

where do is the thickness of said active layer, $V_0$ is, however, if said active layer is a quantum well, defined such as:

$$V_0 = N \cdot \pi \cdot d_W \, / \, \lambda \cdot ( \, N_1^2 - N_0^2 \, )^{0.5}$$

where $d_W$ is the thickness of said quantum well layer, $N_1$ is the refractive index of said quantum well, $N_0$ is the refractive index of said wave guide layer, and N is the number of said quantum wells, and then a relationship of $V_0/3 < V_1 < V_0$ is established.

4. The semiconductor laser element according to claim 1, characterized in that an energy gap difference E (eV) between said wave guide layer and said carrier block layer is given by:

$$E > 2.5 \times 10 \, / \, d^2$$

where d in the unit of nm is the thickness of said carrier block layer.

5. The semiconductor laser element according to claim 4, characterized in that $Al_xGa_{1-x}As$ with $0 \leq x < 1$, is employed, and the composition of said wave guide layer is:

$$Al_xGa_{1-x}As \quad 0 \leq x < 0.35$$

6. The semiconductor laser element according to claim 5, a relationship between $\Delta X$ and $d_1$(nm) falls within the

following range

$$2.2 \times 10/d_1{}^2 < \Delta X < 5.0 \times 10^2/d_1{}^2$$

where $\Delta X$ is the aluminum composition difference between said carrier block layer ($X_1$) and said wave guide layer ($X_2$): ($\Delta X = X_1 - X_2$), and $d_1$ is the thickness of said carrier block layer.

7. A laser device using said semiconductor laser element according to any of claims 1 through 6.

8. A semiconductor laser excitation solid-state laser device using said semiconductor laser element according to any of claims 1 through 6 as a laser excitation light source.

9. The semiconductor laser excitation solid-state laser device according to claim 8, characterized in that the excitation light outputted from said laser element enters a solid-state laser without employing a lens.

10. The semiconductor laser element according to claim 1, characterized in that said bandgap of said wave guide layer has a planar or spherical oblique profile where said bandgap becomes narrower as approaching said carrier block layer.

**Patentansprüche**

1. Halbleiterlaserelement, umfassend:

   a) eine aktive Schicht (4, 12, 13, 14) mit einer Lichtführungsfunktion;

   b) Trägersperrschichten (3, 5), die auf beiden Seiten außerhalb der aktiven Schicht (4) gebildet sind und einen breiten Bandabstand aufweisen, der ausreichend ist, um eine Trägereingrenzung in der aktiven Schicht (4) zu bewirken, wobei sie in einer vertikalen Richtung von der Oberfläche des Elements gebildet sind und die Lichtführungsfunktion der aktiven Schicht (4) herabsetzen;

   c) Wellenleiterschichten (2, 6), die auf beiden Seiten extern zu den Trägersperrschichten (3, 5) vorgesehen sind; und

   d) Ummantelungsschichten (1, 7), die so vorgesehen sind, daß die Wellenleiterschichten (2, 6) dazwischen eingebettet sind;

   **dadurch gekennzeichnet, daß**

   e) $V_1$, $V_2$ die normalisierten Frequenzen V eines Modes in den Trägersperrschichten (3, 5) bzw. den Ummantelungsschichten (1, 7) sind:

   $$V_1 = \pi \cdot d_1 / \lambda \cdot ( N_0^2 - N_2^2 )^{0.5}$$

   $$V_2 = \pi \cdot d_2 / \lambda \cdot ( N_0^2 - N_3^2 )^{0.5}$$

   wobei $\pi$ das Verhältnis des Umfangs eines Kreises zu seinem Durchmesser ist, $d_1$ die Dicke der Trägersperrschicht ist, $d_2$ die Dicke zwischen zwei Ummantelungsschichten ist, $\lambda$ die Oszillationswellenlänge ist, $N_0$ der Brechungsindex der Wellenleiterschicht oder deren maximaler Wert ist, wenn der Brechungsindex der Wellenleiterschicht sich kontinuierlich ändert, $N_2$ der Brechungsindex der Trägersperrschicht ist und $N_3$ der Brechungsindex der Ummantelungsschicht ist und dann eine Beziehung von $V_1 < V_2 / 10$ eingestellt wird.

2. Halbleiterlaserelement nach Anspruch 1,
   **dadurch gekennzeichnet, daß** ferner eine Beziehung von

EP 0 578 836 B1

$$\pi/2 < V_2 < 3,5$$

eingestellt wird.

3. Halbleiterlaserelement nach Anspruch 1,
**dadurch gekennzeichnet, daß** die normalisierte Frequenz $V_0$ eines Modes in der aktiven Schicht folgendermaßen gegeben ist:

$$V_0 = \pi \cdot d_0 / \lambda \cdot ( N_1^2 - N_0^2 )^{0.5}$$

wobei $d_0$ die Dicke der aktiven Schicht ist, $V_0$ jedoch dann, wenn die aktive Schicht eine Quantumwanne ist, folgendermaßen definiert ist:

$$V_0 = N \cdot \pi \cdot d_W / \lambda \cdot ( N_1^2 - N_0^2 )^{0.5}$$

wobei $d_W$ die Dicke der Quantumwannenschicht ist, $N_1$ der Brechungsindex der Quantumwanne ist, $N_0$ der Brechungsindex der Wellenleiterschicht ist, und N die Anzahl der Quantumwannen ist, und dann eine Beziehung von $V_0/3 < V_1 < V_0$ eingestellt wird.

4. Halbleiterlaserelement nach Anspruch 1,
**dadurch gekennzeichnet, daß** eine
Energieabstandsdifferenz E (eV) zwischen der Wellenleiterschicht und der Trägersperrschicht folgendermaßen gegeben ist:

$$E > 2,5 \times 10 / d^2$$

wobei d in der Einheit von nm die Dicke der Trägersperrschicht ist.

5. Halbleiterlaserelement nach Anspruch 4,
**dadurch gekennzeichnet, daß** $Al_xGa_{1-x}As$ mit $0 \leq x < 1$ verwendet wird und die Zusammensetzung der Wellenleiterschicht folgendermaßen ist:

$$Al_xGa_{1-x}As \quad 0 \leq x < 0,35.$$

6. Halbleiterlaserelement nach Anspruch 5,
**dadurch gekennzeichnet, daß** ein Zusammenhang zwischen $\Delta X$ und $d_1$ (nm) in den folgenden Bereich fällt:

$$2,2 \times 10/d_1^2 < \Delta X < 5,0 \times 10^2/d_1^2$$

wobei $\Delta X$ die Aluminiumzusammensetzungsdifferenz zwischen der Trägersperrschicht ($X_1$) und der Wellenleiterschicht ($X_2$) ist: ($\Delta X = X_1 - X_2$), und $d_1$ die Dicke der Trägersperrschicht ist.

7. Lasereinrichtung unter Verwendung des
Halbleiterlaserelements nach einem der Ansprüche 1 bis 6.

8. Festkörperlasereinrichtung mit einer Halbleiterlaseranregung unter Verwendung des Halbleiterlaserelements nach einem der Ansprüche 1 bis 6 als eine Laseranregungslichtquelle.

9. Festkörperlasereinrichtung mit einer Halbleiterlaseranregung nach Anspruch 8,
**dadurch gekennzeichnet, daß** das Anregungslicht, das von dem Laserelement ausgegeben wird, ohne Verwendung einer Linse in den Festkörperlaser eintritt.

28

**10.** Halbleiterlaserelement nach Anspruch 1,
**dadurch gekennzeichnet, daß** der Bandabstand der Wellenleiterschicht ein planares oder kugelförmiges schräges Profil aufweist, bei dem der Bandabstand bei Annäherung an die Trägersperrschicht schmaler wird.

## Revendications

**1.** Élément laser à semi-conducteur, comprenant :

a) une couche (4, 12, 13, 14) active ayant une fonction de guidage de la lumière ;
b) des couches (3, 5) de blocage des porteurs formées de façon bilatérales à l'extérieur de ladite couche (4) active, ayant une bande interdite suffisamment large pour produire un confinement des porteurs dans ladite couche (4) active, formées dans une direction verticale à partir de la surface dudit élément et réduisant la fonction de guidage de lumière de ladite couche (4) active ;
c) des couches (2, 6) formant guides d'ondes disposées de façon bilatérale à l'extérieur desdites couches (3, 5) de blocage des porteurs ; et
d) des couches (1, 7) de placage disposées de façon à ce que lesdites couches (2, 6) formant guide d'onde soient intercalées entre celles-ci ;

caractérisé en ce que

e) $V_1$, $V_2$ sont respectivement les fréquences normalisées V d'un mode dans les couches (3, 5) de blocage des porteurs et les couches (1, 7) de placage :

$$V_1 = \pi.d_1 / \lambda. ( N_0^2 - N_2^2 )^{0,5}$$

$$V_2 = \pi.d_2 / \lambda. ( N_0^2 - N_3^2 )^{0,5}$$

où $\pi$ est le rapport de la circonférence d'un cercle à son diamètre, $d_1$ est l'épaisseur de ladite couche de blocage des porteurs, $d_2$ est l'épaisseur entre lesdites deux couches de placage, $\lambda$ est la longueur d'onde d'oscillation, $N_0$ est l'indice de réfraction de ladite couche formant guide d'ondes ou son maximum, si l'indice de réfraction de ladite couche formant guide d'ondes varie continûment, $N_2$ est l'indice de réfraction de ladite couche de blocage des porteurs, et $N_3$ est l'indice de réfraction de ladite couche de placage, de sorte que la relation $V_1 < V_2/10$ est établie.

**2.** Élément laser à semi-conducteur selon la revendication 1, caractérisé en ce qu'en outre la relation suivante :

$$\pi/2 < V_2 < 3,5$$

est établie.

**3.** Élément laser à semi-conducteur selon la revendication 1, caractérisé en ce que la fréquence normalisée $V_0$ d'un mode dans la couche active est donnée par :

$$V_0 = \pi.d_0/\lambda. ( N_1^2 - N_0^2 )^{0,5}$$

où $d_0$ est l'épaisseur de ladite couche active, $V_0$ est, si ladite couche active est cependant un puits quantique, défini de telle façon que :

$$V_0 = N.\pi.d_w / \lambda. ( N_1^2 - N_0^2 )^{0,5}$$

où $d_w$ est l'épaisseur de ladite couche de puits quantique, $N_1$ est l'indice de réfraction de ladite couche de puits quantique, $N_0$ est l'indice de réfraction de ladite couche formant guide d'ondes, et N est le nombre desdits puits quantiques, de sorte que la relation $V_0/3 < V_1 < V_0$ est établie.

4. Élément laser à semi-conducteur selon la revendication 1, caractérisé en ce que la différence d'énergie de bande interdite E (eV) entre ladite couche formant guide d'ondes et ladite couche de blocage des porteurs, est donnée par :

$$E > 2,5 \times 10 / d^2$$

où d est l'épaisseur, en nanomètres, de ladite couche de blocage des porteurs.

5. Élément laser à semi-conducteur selon la revendication 4, caractérisé en ce que de l'$Al_xGa_{1-x}As$, avec $0 \leq x < 1$ est utilisé, et en ce que la composition de ladite couche formant guide d'ondes est :

$$Al_xGa_{1-x}As \; 0 \leq x < 0,35.$$

6. Élément laser à semi-conducteur selon la revendication 5, dans lequel la relation entre $\Delta X$ et $d_1$ (nanomètres) se situe dans l'intervalle suivant :

$$2,2 \times 10/d_1^2 < \Delta X < 5,0 \times 10^2/d_1^2$$

où $\Delta X$ est la différence de composition en aluminium entre ladite couche ($X_1$) de blocage des porteurs et ladite couche ($X_2$) formant guide d'ondes : ($\Delta X = X_1 - X_2$) et $d_1$ est l'épaisseur de ladite couche de blocage des porteurs.

7. Dispositif à laser utilisant ledit élément laser à semi-conducteur selon l'une quelconque des revendications 1 à 6.

8. Dispositif à laser à semi-conducteur à excitation par un laser à semi-conducteur utilisant ledit élément laser à semi-conducteur selon l'une quelconque des revendications 1 à 6 en tant que source de lumière d'excitation de laser.

9. Dispositif à laser à semi-conducteur à excitation par un laser à semi-conducteur selon la revendication 8, caractérisé en ce que la lumière d'excitation fournie en sortie par ledit élément laser pénètre dans ledit laser à semi-conducteur sans utilisation de lentille.

10. Élément laser à semiconducteur selon la revendication 1, caractérisé en ce que ladite bande interdite de ladite couche formant guide d'ondes présente un profil oblique plan ou sphérique, ladite bande interdite devenant plus étroite lorsqu'on se rapproche de ladite couche de blocage des porteurs.

FIG.1(a)

BANDGAP (Al COMPOSITION IN GaAlAs SYSTEM)

REFRACTIVE INDEX

FIG.1(b)

BANDGAP (Al COMPOSITION IN GaAlAs SYSTEM)

REFRACTIVE INDEX

FIG.1(c)

BANDGAP (Al COMPOSITION IN GaAlAs SYSTEM)

REFRACTIVE INDEX

FIG.1(d)

ENLARGED VIEW

FIG.1(e)

# F.IG.2

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# FIG.3

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# F I G.4

11.. CAP LAYER
7.. P-TYPE CLAD LAYER
15.. N-TYPE INVERSION LAYER
6.. P-TYPE LIGHT WAVE GUIDE LAYER
4.. ACTIVE LAYER
2.. N-TYPE LIGHT WAVE GUIDE LAYER
1.. N-TYPE CLAD LAYER
10..BUFFER LAYER

8.. SUBSTRATE

5.. P-TYPE CARRIER BLOCK LAYER
12.. SIDE BARRIER LAYER
13.. QUANTUM WELL LAYER
14.. BARRIER LAYER

3.. N-TYPE CARRIER BLOCK LAYER

VIEW OF ACTIVE LAYER ENERGY BAND

# FIG.5

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# FIG.6

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# F I G.7

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# FIG.8

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# FIG.9

11.. CAP LAYER

7.. P-TYPE CLAD LAYER.

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# FIG.10

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# F I G.11

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# FIG.12

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER LAYER

3.. N-TYPE CARRIER BLOCK

VIEW OF ACTIVE LAYER ENERGY BAND

# F I G.13

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# F I G.14

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# F I G.15

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# FIG.16

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# F I G.17

11.. CAP LAYER

7.. P-TYPE CLAD LAYER

6.. P-TYPE LIGHT WAVE GUIDE LAYER

4.. ACTIVE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13..QUANTUM WELL LAYER

14.. BARRIER LAYER

3.. N-TYPE CARRIER BLOCK LAYER

VIEW OF ACTIVE LAYER ENERGY BAND

# F I G.18

11.. CAP LAYER

7.. P-TYPE CLAD LAYER

6.. P-TYPE LIGHT WAVE

4.. ACTIVE LAYER GUIDE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK LAYER

VIEW OF ACTIVE LAYER ENERGY BAND

# FIG.19

11.. CAP LAYER

7.. P-TYPE CLAD LAYER

6.. P-TYPE LIGHT WAVE

4.. ACTIVE LAYER GUIDE LAYER

2.. N-TYPE LIGHT WAVE GUIDE LAYER

1.. N-TYPE CLAD LAYER

10.. BUFFER LAYER

8.. SUBSTRATE

5.. P-TYPE CARRIER BLOCK LAYER

12.. SIDE BARRIER LAYER

13.. QUANTUM WELL LAYER

14.. BARRIER LAYER

3.. N-TYPE CARRIER BLOCK

VIEW OF ACTIVE LAYER ENERGY BAND

# F I G.20

11.. CAP LAYER

7.. P-TYPE CLAD LAYER

4.. ACTIVE LAYER

1.. N- TYPE CLAD LAYER

10.. BUFFER LAYER

8.. SUBSTRATE

12.. SIDE BARRIER LAYER

13.. QUANTUM WELL LAYER

14.. BARRIER LAYER

VIEW OF ACTIVE LAYER ENERGY BAND

# FIG.21

EPITAXY VERTICAL DIRECTION ($\mu$m)

GUIDED MODE

# FIG.22

RADIATION MODE

# FIG.23

EMBODIMENT 4
EMBODIMENT 5
EMBODIMENT 6
EMBODIMENT 7

RELATIVE AMPLITUDE

EPITAXY VERTICAL DIRECTION ($\mu$m)

GUIDED MODE

# FIG.24

RADIATION MODE

# FIG.25

EPITAXY VERTICAL DIRECTION (μm)

GUIDED MODE

# F I G.26

RADIATION MODE

# FIG.27

EPITAXY VERTICAL DIRECTION (μm)

GUIDED MODE

# FIG.28

RADIATION MODE

# FIG.29

EPITAXY VERTICAL DIRECTION (μm)

GUIDED MODE

# FIG.30

RADIATION MODE

# FIG.31

ANTI-GUIDING CARRIER BLOCK LAYER THICKNESS (Å)

# FIG.32

# FIG.33